# EUROPEAN PATENT APPLICATION

(11) **EP 1 962 546 A2**
(43) Date of publication of application: **27.08.2008**
(21) Application number: 08002950.7
(22) Date of filing: 18.02.2008
(51) Int. Cl.: H04R 1/32, H04R 3/00, H04R 19/00

(54) **Sensitive silicon microphone with wide dynamic range**

(30) Priority: 26.02.2007 JP 2007045296
(71) Applicant: YAMAHA CORPORATION, Naka-ku Hamamatsu-shi Shizuoka-ken (JP)
(72) Inventor: Torii, Junji, Shizuoka-ken (JP); Hirade, Seiji, Shizuoka-ken (JP); Yoshimura, Katsuju, Shizuoka-ken (JP); Omura, Masayoshi, Shizuoka-ken (JP)
(74) Representative: Wagner, Karl H.

(57) **Abstract**

A silicon microphone on which four acoustic transducers are integrated, having different values of sensitivity and, accordingly, different values of dynamic range; the analog acoustic signals are supplied from the four acoustic transducers to the integrated circuit device, and are converted to digital acoustic signals; the digital acoustic signal output from the acoustic transducers with relatively high sensitivity acoustic transducers are normalized with respect to the digital acoustic signal output from the acoustic transducer with lowest sensitivity, and the normalized digital acoustic signals are selectively formed into a composite acoustic signal depending upon the sound pressure of sound waves so that the dynamic range is expanded without sacrifice of high sensitivity in the low sound pressure range.

## Description

### FIELD OF THE INVENTION

This invention relates to a microphone and, more particularly, to an electrostatic microphone fabricated on a semiconductor substrate.

### DESCRIPTION OF THE RELATED ART

Growing research and development efforts are being made for miniature microphones. Various approaches have been proposed. One of the approaches is disclosed in Japan Patent Application laid-open No. 2001-169395. The prior art miniature microphone disclosed in the Japan Patent Application laid-open is of the type optically converting vibrations of extremely thin vibratory plates to an electric signal, and, accordingly, is called as "an optical microphone".

The prior art optical microphone is hereinafter described. An inner space is defined inside a package, and is divided into plural chambers by means of photo-shield walls. The chambers are respectively assigned to acoustic transducers, i.e., acoustic waves-to-electric signal converters, and each of the acoustic transducers is constituted by a substrate of gallium arsenide and an extremely thin vibratory plate. A laser diode and photo-diodes are integrated on the gallium arsenide substrate, and are opposed to the extremely thin vibratory plate. The laser diode emits the light to the extremely thin vibratory plate, and the light is reflected thereon. The reflected light is incident on the photo-diodes, and is converted to photo-current. The acoustic waves give rise to vibrations of the extremely thin vibratory plates, and cause the amount of incident light to be varied in the chambers. Accordingly, the amount of photo-current is varied together with the vibrations of vibratory plates. The prior art optical microphone aims at response to the sound waves in a wide frequency range. The acoustic converters have different frequency ranges partially overlapped with the adjacent frequency ranges so as to make the prior art optical microphone respond to the wide frequency range.

Recent development of MEMS (Micro Electro Mechanical Systems) technologies makes it possible to fabricate an electrostatic microphone on a silicon chip. The miniature electrostatic microphone is called as "a silicon microphone". A typical example of the silicon microphone has a diaphragm and a back plate, both formed on a silicon chip through the micro fabrication techniques. The diaphragm is spaced from the back plate by an air gap so as to form a condenser together with the back plate. While sound waves are exerting force on the diaphragm, the diaphragm is deformed, and, accordingly, the condenser varies the capacitance together with the sound pressure. An electric signal representative of the capacitance is taken out from the condenser. Thus, the silicon microphone converts the sound waves to the electric signal.

The silicon microphone makes the amplitude of the electric signal well proportional to the sound pressure in so far as the sound pressure does not exceed a critical value. However, the silicon microphone does not enlarge the amplitude of electric signal after the sound pressure exceeds the critical value. In other words, the electric signal is saturated.

The sound pressure at the critical value is called as "saturated sound pressure". Term "unsaturated sound pressure range" means the range of sound pressure less than the saturated sound pressure, and is a synonym of "dynamic range". When the sound pressure is exerting the sound pressure equal to or greater than the saturated sound pressure, the silicon microphone enters "saturated state".

In the following description, term "sound pressure" means an amplitude of pressure or a difference between the highest value of pressure and the next lowest value of the pressure, and is corresponding to the amplitude of the electric signal taken out from an ideal microphone, which makes the amplitude of electric signal proportional to the sound pressure without the saturated state. On the other hand, term "amplitude" is the difference between the lowest peak value and the highest peak value of the electric signal output from a real silicon microphone.

Term "sensitivity" is another figure expressing the capability of silicon microphone, and is defined as "a rate of change of the amplitude of electric signal in terms of a unit pressure of sound propagating medium." A silicon microphone with a high sensitivity can convert faint sound to the electric signal. However, the silicon microphone enters the saturated state at a relatively small value of the saturated sound pressure. On the other hand, a silicon microphone with a lower sensitivity has a wide dynamic range. However, it is hard to convert faint sound to the electric signal. Thus, there is a trade-off between the dynamic range and the sensitivity.

It is important for application designers to keep the silicon microphones unsaturated state in their application put in their operation environments. However, it is difficult to for designers of a general purpose silicon microphone exactly to forecast all the operation environments.

Although plural acoustic transducers are found to form a prior art microphone device for giving directionality to the prior art microphone device, the plural acoustic transducers make the prior art directional microphone device bulky. In other words, it is difficult to fabricate a compact directional microphone device from the plural acoustic transducers.

### SUMMARY OF THE INVENTION

It is therefore an important object of the present invention to provide a semiconductor microphone, which has a wide dynamic range and a high sensitivity in a relatively low sound pressure range.

It is another important object of the present invention to provide a signal processing system, which forms a part of the semiconductor microphone.

It is yet another important object of the present invention to provide a compact directional semiconductor microphone.

To accomplish the object, the present invention proposes to produce a composite acoustic signal representative of the sound waves from intermediate acoustic signals output from plural acoustic transducers different in sensitivity and saturated sound pressure.

In accordance with one aspect of the present invention, there is provided a semiconductor microphone connected to a signal processor for converting sound waves to plural intermediate acoustic signals, the signal processor carries out a signal processing on said intermediate acoustic signals so as to produce a composite acoustic signal, and the semiconductor microphone comprises a housing having an inner space and formed with a sound hole, which permits the sound waves to enter the inner space, and plural acoustic transducers accommodated in the inner space, having respective values of sensitivity different from one another and respective values of saturated sound pressure of the sound waves different from one another, converting the sound waves to the plural intermediate acoustic signals, respectively, and providing the plural intermediate acoustic signals to the signal processor.

In accordance with another aspect of the present invention, there is provided a semiconductor microphone for converting sound waves to a composite acoustic signal comprising a housing having an inner space and formed with plural sound holes which permit the sound waves to enter the inner space, a partition wall structure provided in the inner space so as to divide the inner space into plural compartments open to the outside of the housing selectively through the plural sound holes, plural acoustic transducers respectively provided in the plural compartments and converting the sound waves to plural intermediate acoustic signals, and a signal processor connected to the plural acoustic transducers, introducing delay into selected ones of the plural intermediate acoustic signals so as to produce delayed acoustic signals and forming a composite acoustic signal from the delayed acoustic signals, thereby giving directivity to the semiconductor microphone.

### BRIEF DESCRIPTION OF THE DRAWINGS

The features and advantages of the silicon microphone will be more clearly understood from the following description taken in conjunction with the accompanying drawings, in which
Fig. 1A is a plane view showing the arrangement of components of a silicon microphone of the present invention,
Fig. 1B is a block diagram showing the system configuration of the silicon microphone,
Fig. 2 is a cross sectional view taken along line III - III of figure 1A and showing the structure of the silicon microphone,
Fig. 3 is a cross sectional view showing the structure of acoustic transducers incorporated in the silicon microphone,
Fig. 4 is a plane view showing diaphragms of the acoustic transducers,
Figs. 5A to 5C are cross sectional views showing a process for fabricating the silicon microphone device,
Fig. 6 is a cross sectional view showing the structure of acoustic transducers incorporated in another silicon microphone,
Fig. 7 is a block diagram showing the function of an information processing system incorporated in the silicon microphone,
Fig. 8 is a graph showing relations between acoustic signals and sound pressure,
Fig. 9 is a graph showing coefficients of cross fading in terms of time,
Figs. 10A to 10C are flowcharts showing a job sequence realized through the execution of a computer program,
Fig. 11 is a block diagram showing the function of another silicon microphone of the present invention,
Fig. 12 is a diagram showing intermediate acoustic signals of the silicon microphone and composite acoustic signals produced from the intermediate acoustic signals,
Fig. 13 is a block diagram showing the function of yet another silicon microphone of the present invention,
Fig. 14 is a block diagram showing the function of still another silicon microphone of the present invention,
Fig. 15 is a block diagram showing a normalizing function in the silicon microphone,
Fig. 16A is a plane view showing the arrangement of yet another silicon microphone of the present invention,
Fig. 16B is a block diagram showing the system configuration of an integrated circuit device of the silicon microphone,
Fig. 17 is a cross sectional view taken along line V-V of figure 16A and showing the structure of the silicon microphone,
Fig. 18 is a block diagram showing the function of an integrated circuit device of the silicon microphone,
Fig. 19 is a diagram showing the concept of endowment of directivity, and
Fig. 20 is a block diagram showing the function of the information processing system incorporated in still another silicon microphone of the present invention.

### DESCRIPTION OF THE PREFERRED EMBODIMENTS

A semiconductor microphone embodying the present invention is used for converting sound waves to intermediate acoustic signals. A signal processor carries out a signal processing on the intermediate acoustic signals so as to produce a composite acoustic signal.

The semiconductor microphone comprises housing and plural acoustic transducers. The housing has an inner space, and is formed with a sound hole. The plural acoustic transducers are accommodated in the inner space. Since the sound hole permits the sound waves to enter the inner space, the sound waves reach the plural acoustic transducers, and are converted to the plural intermediate acoustic signals by means of the plural acoustic transducers.

The plural acoustic transducers have respective values of sensitivity different from one another and respective values of saturated sound pressure different from one another. Namely, the plural acoustic transducers are different in sensitivity and saturated sound pressure from one another. A certain potential level of the plural intermediate acoustic signals is representative of different values of sound pressure. The plural intermediate acoustic signals are provided from the plural acoustic transducers to the signal processor, and the composite acoustic signal is produced from the plural intermediate acoustic signals through the data processing.

Since the plural intermediate acoustic transducers are different in saturated sound pressure from one another, the composite acoustic signal has an unsaturated region wider than each of the plural intermediate acoustic signals. Thus, the semiconductor microphone embodying the present invention makes it possible to produce the composite acoustic signal with the wide unsaturated region. Moreover, the plural acoustic transducers are integrated inside the housing so that the semiconductor microphone is compact.

Another semiconductor microphone embodying the present invention largely comprises a housing, a partition wall structure, plural acoustic transducers and a signal processor, and converts sound waves to a composite acoustic signal. The housing has an inner space, and is formed with plural sound holes. The partition wall structure is provided inside the housing so that the inner space is divided into plural compartments. The plural sound holes permit the sound waves to enter the inner space, i.e., the plural compartments. In other words, the plural compartments are acoustically open to the outside of the housing through the plural sound holes.

The plural acoustic transducers are respectively provided in the plural compartments, and convert the sound waves to plural intermediate acoustic signals. The signal processor is connected to the plural acoustic transducers so that the plural intermediate acoustic signals are supplied from the plural acoustic transducers to the signal processor for the signal processing. The signal processor introduces delay into selected ones of the plural intermediate acoustic signals so as to produce delayed acoustic signals. The signal processor produces the composite acoustic signal from the delayed acoustic signals. Since the plural sound holes are differently spaced from an origin of the sound waves, the sound holes give directivity to the semiconductor microphone.

In the following description on embodiments of the present invention, term "sound pressure" means an amplitude of pressure or a difference between the highest value of pressure and the next lowest value of the pressure, and is corresponding to the amplitude of the electric signal taken out from an ideal microphone, which makes the amplitude of electric signal proportional to the sound pressure without the saturated state. On the other hand, term "amplitude" is the difference between the lowest peak value and the highest peak value of the electric signal output from a real silicon microphone.

Term "sensitivity" is another figure expressing the capability of silicon microphone, and is defined as "a rate of change of the amplitude of electric signal in terms of a unit pressure of sound propagating medium."

### First Embodiment

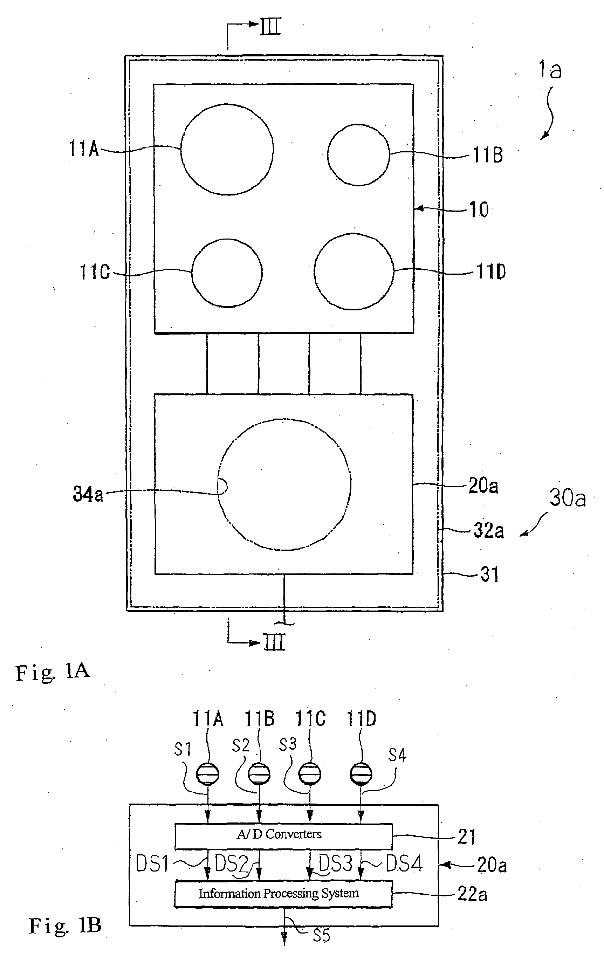

Referring first to figures 1A and 1B of the drawings, a silicon microphone 1a embodying the present invention largely comprises a silicon microphone device 10, an integrated circuit device 20a and a single package 30a. The silicon microphone 1a is, by way of example, provided in a mobile telephone and a PDA (Personal Digital Assistant).

An inner space is defined inside the package 30a, and the silicon microphone device 10 and integrated circuit device 20a are accommodated in the package 30a. The package 30a is formed with a sound hole 34a. Since a lid 32a is removed from the package 30a shown in figure 1A, dots-and-dash line is indicative of the location of the sound hole 34a. The sound waves enter the inner space through the sound hole 34a, and reach the silicon microphone device 10.

The silicon microphone device 10 is electrically connected to the integrated circuit device 20a. The sound waves are converted to four intermediate acoustic signals S1, S2, S3 and S4 through the silicon microphone device 10, and the intermediate acoustic signals S1, S2, S3 and S4 are supplied from the silicon microphone device 10 to the integrated circuit device 20a. The intermediate acoustic signals S1, S2, S3 and S4 are produced in the silicon microphone device 10 on the condition that the silicon microphone device 10 changes the sensitivity thereof among different four values. The integrated circuit device 20a produces a composite acoustic signal S5 on the basis of the intermediate acoustic signals S1, S2, S3 and S4. While the sound waves is exhibiting relatively low value of sound pressure, the composite acoustic signal S5 is equivalent to an acoustic signal produced through a silicon microphone with a high sensitivity. On the other hand, while the sound waves have relatively high values of sound pressure, the composite acoustic signal S5 is equivalent to an acoustic signal produced through a silicon microphone with a low sensitivity. Thus, the silicon microphone 1a exhibits a variable sensitivity. Thus, the silicon microphone 1a achieves a wide dynamic range by virtue of the variable sensitivity.

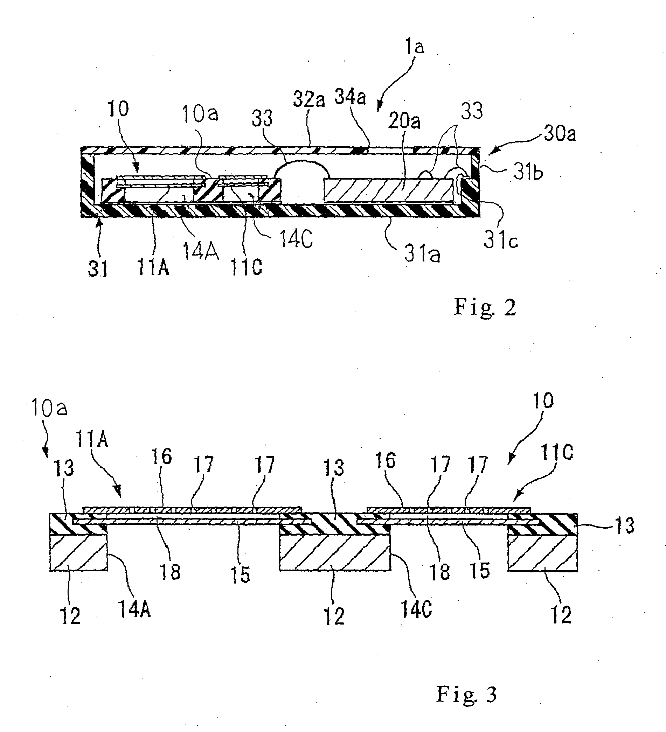

Figure 2 shows the structure of the silicon microphone 1a. The package 30a is broken down into a circuit board 31 and a lid 32a. A flat portion 31a, a wall portion 31b and conductive leads (not shown) form in combination with the package 30a. A conductive pattern 31c is printed on the flat portion, and is connected to the conductive leads. The silicon microphone device 10 and integrated circuit device 20a are mounted on an inner surface of the flat portion 31a, and the wall portion 31b projects from the periphery of the flat portion 31a in the normal direction to the upper surface. Thus, the wall portion 31b forms an opening. The opening is closed with the lid 32a so that the silicon microphone device 10 and integrated circuit device 20a are accommodated in the inner space. The lid 32a is spaced from an upper surface of the silicon microphone device 10 and an upper surface of the integrated circuit device 20a.

The sound hole 34a is located over the integrated circuit device 20a, and the silicon microphone device 10 is offset from the sound hole 34a. This is because of the fact that the moisture in breath and saliva are liable to invade the space beneath the sound hole 34a. The offset arrangement prevents the silicon microphone device 10 from the moisture and saliva.

Conductive pads (not shown) are formed on the upper surface of silicon microphone device 10 and the upper surface of integrated circuit device 20a. Several conductive pads on the silicon microphone device 10 are connected through pieces of conductive wire 33 to the conductive pads, which serve as signal input nodes, of the integrated circuit device 20a, and other conductive pads, which serve as signal output nodes, are connected to the conductive leads through the conductive pattern 31c. Electric power and ground potential are supplied to the silicon microphone device 10 and integrated circuit device 20a through other conductive leads.

Thus, the silicon microphone device 10 and integrated circuit device 20 are integrated on the substrate 31, and sound waves are converted to the composite acoustic signal S5 through the cooperation between the silicon microphone device 10 and integrated circuit device 20 to the outside of the package 30a.

### Structure of Silicon Microphone Device

The silicon microphone device 10 is fabricated on a silicon substrate through the MEMS technologies. The silicon microphone device 10 largely comprises a frame structure 10a and acoustic transducers 11A, 11B, 11C and 11D. In this instance, four acoustic transducers 11A, 11B, 11C and 11D are integrated in the silicon microphone device 10. Four cylindrical hollow spaces 14A, 14B, 14C and 14D are formed in quarter portions of the frame structure 10a, and extend in parallel to the perpendicular direction of the frame structure 10a. The four cylindrical hollow spaces 14A to 14D are respectively assigned to the four acoustic transducers 11A to 11D, and the four acoustic transducers 11A to 11D are supported by the frame structure 10a.

The four acoustic transducers 11A to 11D are independent of one another, and convert the sound waves to the intermediate acoustic signals S1 to S4, respectively. In other words, the four acoustic transducers 11A to 11D are operative in parallel to one another for producing the intermediate acoustic signals S1 to S4. The acoustic converters 11A to 11D are of the type converting sound waves to the intermediate acoustic signals S1 to S4 through variation of capacitance. The acoustic converters 11A to 11D are different in sensitivity from one another so that the sound waves, which are propagated to the four acoustic converters 11A to 11D, make the intermediate acoustic signals S1 to S4 have the amplitude different from one another.

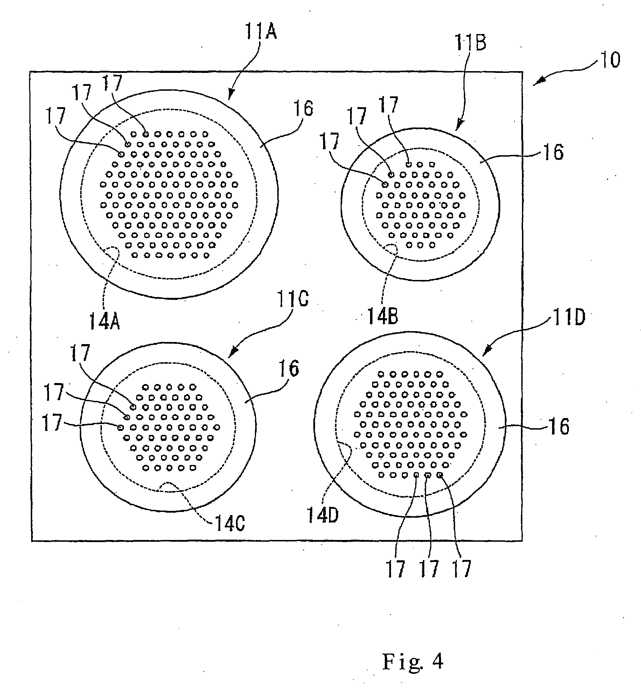

As shown in figures 3 and 4, the frame structure 10a includes a semiconductor substrate 12 and a supporting layer 13 grown on the semiconductor substrate 12. In this instance, the semiconductor substrate 12 is made of single crystalline silicon, and the supporting layer 13 is made of silicon oxide. As described hereinbefore, the cylindrical hollow spaces 14A to 14D are formed in the frame structure 10a in such a manner as to penetrate the supporting layer 13 and silicon substrate 12, and are different in diameter from one another.

Each of the acoustic converters 14A to 14D includes a diaphragm 15 and a back plate 16. The diaphragm 15 and back plate 16 are made of silicon. Plural small through-holes 17 are formed in the back plate 16, and the diaphragm 15 and back plate 16 are supported in parallel to each other by the supporting layer 13. The diaphragm 15 is spaced from the back plate 16 by an extremely narrow gap 18, and the diaphragm 15 and back plate 16 serve as electrodes of a capacitor. The diaphragm 15 is vibratory without respect to the supporting layer 13, and the black plate 16 is stationary with respect to the supporting layer 13. The sensitivity of acoustic converters 11A to 11D is dependent on the area of the diaphragms 15 exposed to the sound waves. Since the peripheral portions of the diaphragms 15 are embedded in the supporting layer 13, the vibratory portions of diaphragms 15 are equal in area to the cross sections of the cylindrical hollow spaces 14A, 14B, 14C and 14D, and the cylindrical hollow spaces 14A to 14D are different in area of cross section from one another. Thus, the cylindrical hollow spaces 14A to 14D make the acoustic converters 11A to 11D different in sensitivity from one another.

When the silicon microphone 1a is energized, the diaphragms 15 are biased to the associated back plates 16, and a potential difference takes place between the diaphragms 15 and the associated back plates 16. Sound waves are assumed to reach the acoustic converters 11A to 11D. While the sound waves are exerting the sound pressure on the diaphragms 15, the sound pressure gives rise to vibrations of the diaphragms 15. The vibrating diaphragms 15 cause the gaps 18 from the associated back plates 16 repeatedly varied, and, accordingly, the capacitance of acoustic converters 11A to 11D is varied in dependence on the gaps 18 from the associated back plates 16. The varied capacitance is taken out from the acoustic converters 11A to 11D as the intermediate acoustic signals S1 to S4.

As described hereinbefore, the diameter of vibratory portions is different from one another. Although the sound waves uniformly exert the sound pressure on all the vibratory portions of diaphragms 15, the flexural rigidity of which is assumed to be equal to one another, the amplitude of the vibrations is different among the diaphragms 15 due to the difference in diameter. The capacitance is varied in dependence on the gaps 18 and, accordingly, the amplitude of vibrations. Thus, the intermediate acoustic signals S1 to S4 have different values of the amplitude in the presence of the same sound waves. In other words, the four acoustic converters 14A to 14D exhibit the sensitivity different from one another.

### Fabrication Process for Acoustic Transducers

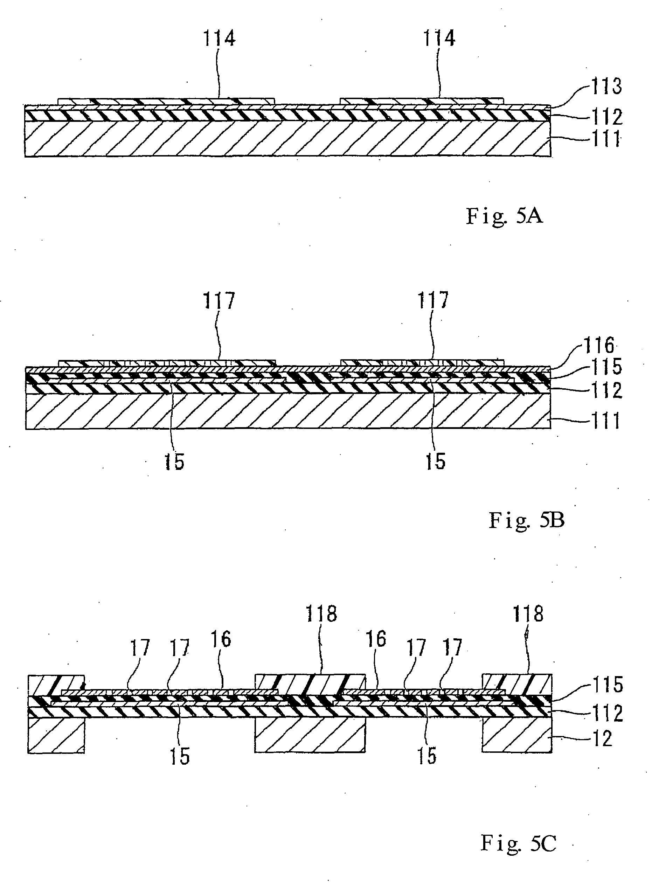

The silicon microphone device 10 is fabricated as follows. Figures 5A to 5C shows a process for fabricating the silicon microphone device 10.

The process starts with preparation of a substrate 111 of single crystalline silicon. Silicon dioxide SiO₂ is deposited over the entire surface of the major surface of the substrate 111 so as to form a silicon oxide layer 112, and, thereafter, polycrystalline silicon is deposited over the entire surface of the silicon oxide layer 112 so that a poly-silicon layer 113 is formed on the silicon oxide layer 112.

The silicon oxide layer 112 serves as a sacrifice layer. In this instance, the silicon oxide and poly crystalline silicon are grown through chemical vapor deposition techniques. While the polycrystalline silicon is being deposited, n-type impurity such as, for example, phosphorus is doped into the polycrystalline silicon by using an in situ doping technique. After the deposition of poly crystalline silicon, P₂O₅ is thermally diffused so that the poly crystalline silicon is heavily doped with the n-type impurity. An ion-implantation may be employed in the introduction of n-type impurity.

Photo-resist solution is spun onto the poly-silicon layer 113, and is baked so as to form a photo-resist layer. A latent image of an etching mask 114 is optically transferred from a photo mask (not shown) to the photo-resist layer, and the latent image is developed so that the etching mask 114 is left on the poly-silicon layer 113 as shown in figure 5A.

The etching mask 114 has four circular disk portions, which are corresponding to the diaphragms 15. The poly-silicon layer 113 is partially etched away in the presence of etchant, and the etching mask 114 prevents the diaphragms 15 from the etchant. As a result, the diaphragms 15 are left on the silicon oxide layer 112. The etching mask 114 is stripped off.

Subsequently, silicon dioxide is deposited on the entire surface of the resultant structure so as to form a silicon oxide layer 115, and, thereafter, poly crystalline silicon is deposited over the silicon oxide layer 115. Boron is also doped into the polycrystalline silicon through the in situ doping technique. The diaphragms 15 is covered with the silicon oxide layer 115, which in turn is covered with a poly-silicon layer 116.

Photo-resist solution is spun onto the entire surface of the poly-silicon layer 116, and is baked for forming a photo-resist layer. A latent image of an etching mask 117 is optically transferred from a photo-mask to the photo-resist layer, and is developed so that the etching mask 117 is left on the poly-silicon layer 116 as shown in figure 5B. The etching mask 117 is formed with through-holes over the areas where the small through-holes 17 are to be formed.

The etching mask 117 has circular disk portions corresponding to the back plates 16. The resultant structure is exposed to etchant. Although the poly-silicon layer 116 is partially removed in the presence of the etchant, the etching mask 117 prevents the back plates 16 from the etchant, and the back plates 16 are left on the silicon oxide layer 115. The etching mask 117 is stripped off.

Subsequently, a photo-resist etching mask (not shown) is patterned on the reverse surface of the substrate 111, and the areas where the cylindrical hollow spaces 14A to 14D are to be formed are not covered with the photo-resist etching mask. The substrate 111 is subjected to a deep RIE (Reactive Ion Etching), i.e., an anisotropic dry etching for achieving large aspect ratio. The substrate 111 is partially etched away until the silicon oxide layer 112 is exposed. Thus, the cylindrical hollow spaces 14A to 14D are formed in the substrate 111. The etching mask is stripped off. The patterned substrate 111 serves as the substrate 12.

Subsequently, a photo-resist etching mask 118 is patterned on the back plates 16. Although the peripheral areas of back plates 16 and peripheral areas of silicon oxide layer 115 around the back plates 16 are covered with the photo-resist etching mask 118, the central areas of back plates 16 are uncovered with the photo-resist etching mask 118. The small through-holes 17 are formed in the central areas of back plates 16. The resultant structure is dipped in wet etchant such as, for example, fluoric acid solution. The fluoric acid solution penetrates into the small through-holes 17, and silicon oxide below the back plates 16 is removed from the resultant structure. As a result, the diaphragms 15 are spaced from the back plates 16 by the gaps 18. The silicon oxide exposed to the cylindrical hollow spaces 14A to 14D is also removed from the resultant structure, and the diaphragms 15 are exposed to the cylindrical hollow spaces 14A to 14D. The photo-resist etching mask 118 is stripped off, and the acoustic converters 11A to 11D, which are supported by the frame structure 10a, are completed. The patterned silicon oxide layers 112 and 115 form in combination the supporting layer 13.

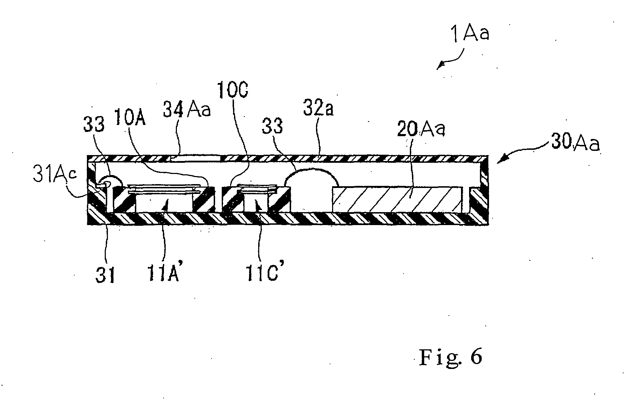

Although the acoustic converters 11A to 11D are integrated on the substrate 12 in the above-described embodiment, acoustic converters 11A', .., 11C', .... , which are different in sensitivity from one another, of another silicon microphone 1A1 may be respectively formed on substrates of individual supporting structures 10A, .., 10C, ..., as shown in figure 6. The silicon microphone 1Aa further comprises an integrated circuit device 20Aa and a package 30Aa. A sound hole 34Aa is formed over the acoustic transducers 11A',..., 11C', ..., and a conductive pattern 31Ac is different from the conductive pattern 31c because of the physically independent acoustic transducers 11A', .., 11C', ... Although the acoustic transducer 11C' is directly connected to the integrated circuit device 20Aa, the other acoustic transducers 11A', ... are connected to the integrated circuit device 20Aa through pieces of conductive wire 33 and the conductive pattern 31Ac. However, the other features of the package 30Aa are similar to those of the package 30a. The other component parts of package 30Aa are labeled with references designating the corresponding component parts of package 30a without detailed description. The integrated circuit device 20Aa is same as the integrated circuit device 20a.

### Integrated Circuit Device

As described hereinbefore, the acoustic transducers 11A to 11D are different in sensitivity from one another. The intermediate acoustic signals S1, S2, S3 and S4 are swung substantially in proportion to the amplitude of vibrations of diaphragms 15 and, accordingly, to the sound pressure. All the intermediate acoustic signals S1 to S4 are saturated at a certain value. In other words, a common dynamic range is found in all the intermediate acoustic signals S1 to S4. The different values of sensitivity means that the intermediate acoustic signals S1 to S4 have respective values of the change of rate of the amplitude of intermediate acoustic signals S1 to S4 in terms of unit value of the sound pressure. For this reason, the saturated amplitude of intermediate acoustic signals expresses different values of sound pressure, i.e., different values of saturated sound pressure PA, PB, PC and PD.

The saturated sound pressure PA, PB, PC and PD are corresponding to the maximum values of sound pressure detectable by the acoustic transducers 11A, 11B, 11C and 11D, respectively. The sensitivity of acoustic transducers 11A, 11B, 11C and 11D is accompanied with "SA", "SB", "SC" and "SD", respectively. The acoustic transducer 11A exhibits the highest sensitivity, and the acoustic transducer 11D exhibits the lowest sensitivity. The sensitivity SA is followed by the sensitivity SB, which in tern is followed by the sensitivity SC, i.e., SA > SB > SC > SD. In other words, the wider the diaphragm is, the higher the sensitivity is.

The integrated circuit device 20a receives the intermediate acoustic signals S1, S2, S3 and S4 from the acoustic transducers 11A to 11D, and carries out data processing on pieces of sound pressure data for producing the composite acoustic signal S5. While the sound pressure is small, the composite acoustic signal S5 is produced from the pieces of sound pressure data output from the acoustic transducer 11A with the highest sensitivity SA. While the sound pressure is being increased from the small sound pressure region, the acoustic transducer is changed from 11A through 11B and 11C to 11D, and the composite acoustic signal S5 is produced from the pieces of sound pressure data output from the selected one of the acoustic transducers 11B, 11C or 11D. Thus, the dynamic range of composite acoustic signal S5 is widened without sacrifice of the high sensitivity in the small sound pressure region.

The integrated circuit device 20a produces the composite acoustic signal S5 on the basis of the intermediate acoustic signals S1 to S4. Analog-to-digital converters 21 and an information processing system 22a are incorporated in the integrated circuit device 20a as shown in figure 1B. The acoustic converters 11A to 11D are connected to the analog-to- digital converters 21 so that discrete values on the waveforms of the intermediate acoustic signals S1 to S4 are periodically sampled at sampling intervals and converted to digital acoustic signals DS1, DS2, DS3 and DS4.

Though not shown in the drawings, the information processing system 22a includes a microprocessor, signal input circuits, a program memory, a non-volatile data storage, a working memory, peripheral processors, signal output circuits and a shared bus system. The microprocessor, input circuits, program memory, working memory, peripheral processors and signal output circuits are connected to the shared bus system so that the microprocessor communicates with the peripheral processors, signal input circuits, program memory, working memory and signal output circuits through the shared bus system. Thus, the microprocessor serves as a central processing unit so as to supervise the other system components.

Critical values of the amplitude which are corresponding to the saturated sound pressure are stored in the non-volatile data storage for the acoustic transducers 11A, 11B and 11C. The acoustic transducer 11A has the smallest value of saturated sound pressure. The value of saturated sound pressure of the acoustic transducer 11B is larger than the value of saturated sound pressure of the acoustic transducer 11A, and is smaller than the value of saturated sound pressure of the acoustic transducer 11C. Accordingly, the critical value for the acoustic transducer 11A is the smallest, and the critical value for the acoustic transducer 11B is larger than the critical value for the acoustic transducer 11A and smaller than the critical value of the acoustic transducer 11C. The acoustic transducer 11D does not enter the saturated state in the dynamic range of acoustic signal S4.

Relations between cross fading coefficients and time are further stored in the non-volatile memory for the four acoustic transducers 11A to 11D. The coefficients of cross fading will be hereinlater described in detail.

### Function of Information Processing System

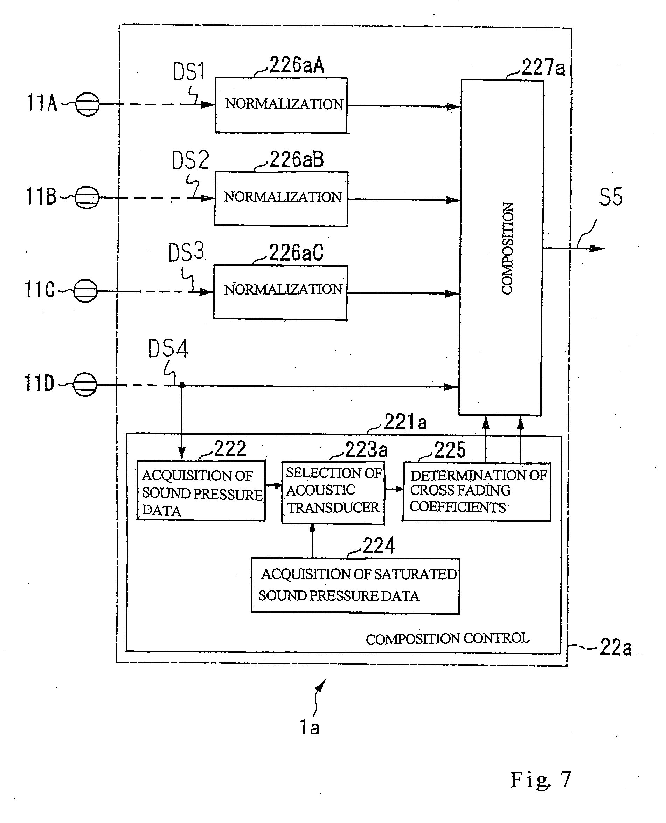

A computer program is stored in the program memory, and runs on the microprocessor so as to realize a function shown in figure 7. The function, which is achieved through the execution of computer program, is hereinafter described with reference to figure 7.

The analog-to-digital converters 21 supplies the digital acoustic signals DS1 to DS4 to the signal input circuits. The microprocessor periodically fetches the discrete values expressed by the digital acoustic signals DS1 to DS4 from the signal input circuits, and the discrete values are temporarily stored in the working memory.

The function is broken down into plural sub-functions, which are referred to as "composition control 221a", "normalization "226aA, 226aB and 226aC" and "composition 227a". The composition control 221a is further broken down into sub-functions referred to as "acquisition of sound pressure data 222", "selection of acoustic transducer 223a", "acquisition of saturated sound pressure data 224" and "determination of cross-fading coefficients". The sub-functions are hereinafter described in detail.

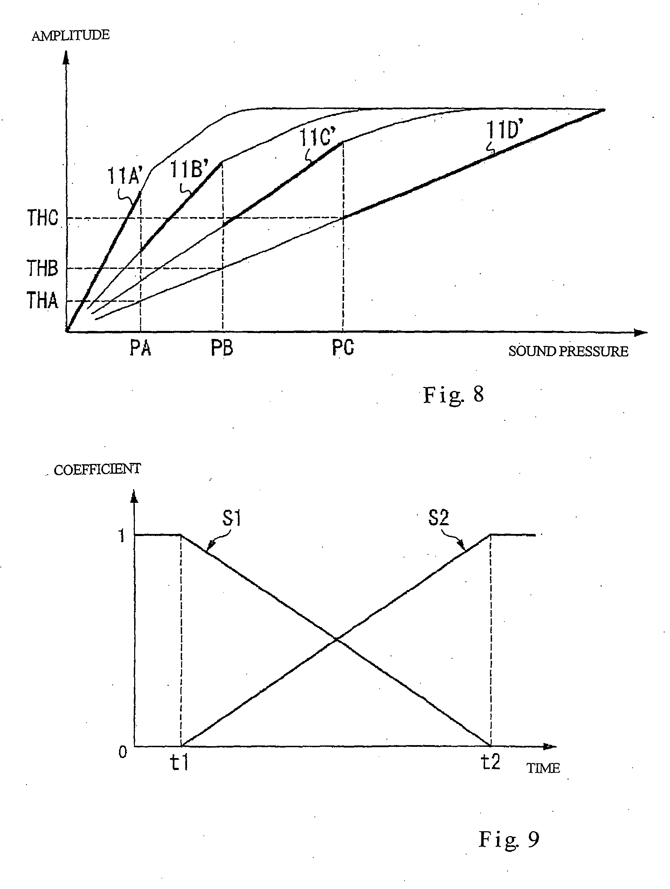

The acoustic digital signals DS1, DS2 and DS3 are normalized through the normalization 226aA, 226aB and 226aC. As described hereinbefore, the acoustic transducers 11A to 11D have difference values of sensitivity SA, SB, SC and SD. Figure 8 shows the amplitude of acoustic signals S1 to S4 in terms of the sound pressure. Plots 11A', 11B', 11C' and 11D' stand for the relations between the amplitude of sound signals S1 to S4 output from the acoustic transducers 11A to 11D and the sound pressure. As will be understood from the plots 11A' to 11D', even if the sound pressure is found at a certain value, the acoustic signals S1 to S4 have different values of the amplitude. The proportional relation on the plots 11A', 11B', 11C' and 11D' are destroyed at the values PA, PB and PC, and the saturated sound pressure is also different among the acoustic transducers 11A to 11D. "PA", "PB" and "PC" are indicative of the saturated sound pressure of the acoustic transducers 11A, 11B and 11C, respectively, and are corresponding to the critical values THA, THB and THC of amplitudes of acoustic signals S1 to S3. Pieces of saturated sound pressure data expresses the critical values THA, THB and THC.

Turning back to figure 7, the normalization 226aA, 226aB and 226aC makes the discrete values of digital acoustic signals DS1 to DS4 changed to normalized discrete values on the assumption that the acoustic transducers 11A, 11B and 11C are equal in sensitivity to the acoustic transducer 11D. The normalization is a preliminary data processing before the composition 227a. The discrete values of digital acoustic signals DS1 to DS4 are normalized through amplification or multiplication by the ratio of sensitivity. The discrete values of digital acoustic signal DS1 are, by way of example, amplified or multiplied by the ratio of SD/ SA. The discrete values of other digital acoustic signal are similarly amplified by SD/ SB and SD/ SC. Thus, the acoustic transducer 11D serves as the standard. For this reason, the normalization is not carried out for the digital acoustic signal DS4.

The composite acoustic signal S5 is produced through the composition 227a. As will be described hereinafter in conjunction with the selection of acoustic transducer 223a, the composite acoustic signal S5 is partially produced from each of the digital acoustic signals DS1 to DS4 and partially from selected two of the digital acoustic signals DS1 to DS4 under the supervision of the composition control 221a.

In order to control the composition, the sound pressure of sound waves is firstly determined through the acquisition of sound pressure data 222. The acoustic transducer 11D has the widest detectable range of sound pressure so that a current discrete value A, i.e., amplitude A, representative of the sound pressure is determined on the basis of an envelope line of discrete value of the digital acoustic signal DS4.

As described hereinbefore, the critical values THA, THB and THC are stored in the non-volatile data storage. The critical values THA, THB and THC are read out from the non-volatile data storage through the acquisition of saturated sound pressure data 224. The current value A of sound pressure are compared with the critical values THA, THB and THC indicative of the saturated sound pressure PA, PB and PC to see what acoustic transducer 11A, 11B, 11C or 11D is to be selected. When the current value A of digital acoustic signal DS4 is less than the critical value THA corresponding to the saturated sound pressure PA, i.e., A < THA, the acoustic transducer 11A is to be selected. When the current value A is fallen within the range equal to or greater than the critical value THA and less than the critical value THB, i.e., THA ≦A< THB, the acoustic transducer 11B is selected from the four. If the current value A is fallen within the range equal to or greater than the critical value THB and less than the critical value THC, i.e., THB ≦ A < THC, the acoustic transducer 11C is selected from the four. When the current value A is equal to or greater than the critical value THC, i.e., THC ≦ A, the acoustic transducer 11D is selected from the four.

While the current value A is not found in the vicinities of critical values THA, THB and THC, the normalized value of digital acoustic signal DS1, DS2, DS3 or DS4 is output from the information processing system 22a as the composite acoustic signal S5. However, if the current value A is found in the vicinity of one of the critical values THA, THB or THC, the corresponding part of the composite acoustic signal S5 is produced through a cross fading technique. In other words, when the current value A is found in the vicinity of critical value THA, THB or THC, the normalized value of discrete acoustic signal DS1, DS2 or DS3 fades out, and the normalized value of discrete acoustic signal DS2, DS3 or DS4 fides in. Coefficients are required for the cross fading, and are determined through the sub-function "determination of cross-fading coefficients".

Figure 9 shows the coefficients of cross fading in terms of time. Plots S1 stands for the coefficient to be applied to the normalized values of an acoustic transducer 11A, 11B or 11C presently used, and plots S2 stands for the coefficients to be applied to the normalized values of an acoustic transducer 11B, 11C or 11D to be changed from the currently used acoustic transducer 11A, 11B or 11C. The coefficient on the plots S1 is decreased with time, and the coefficient on the plots S2 is increased with time.

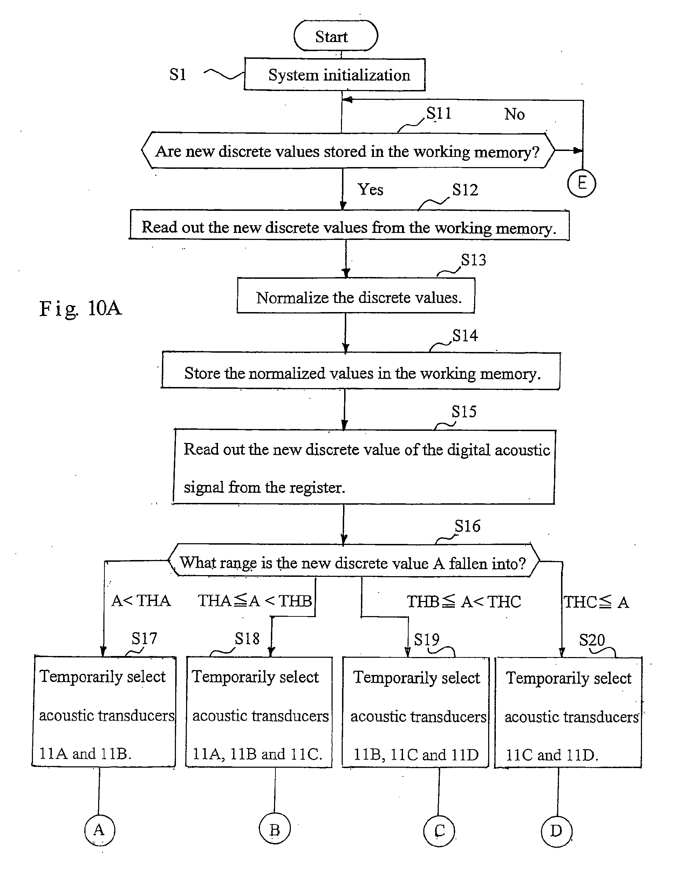

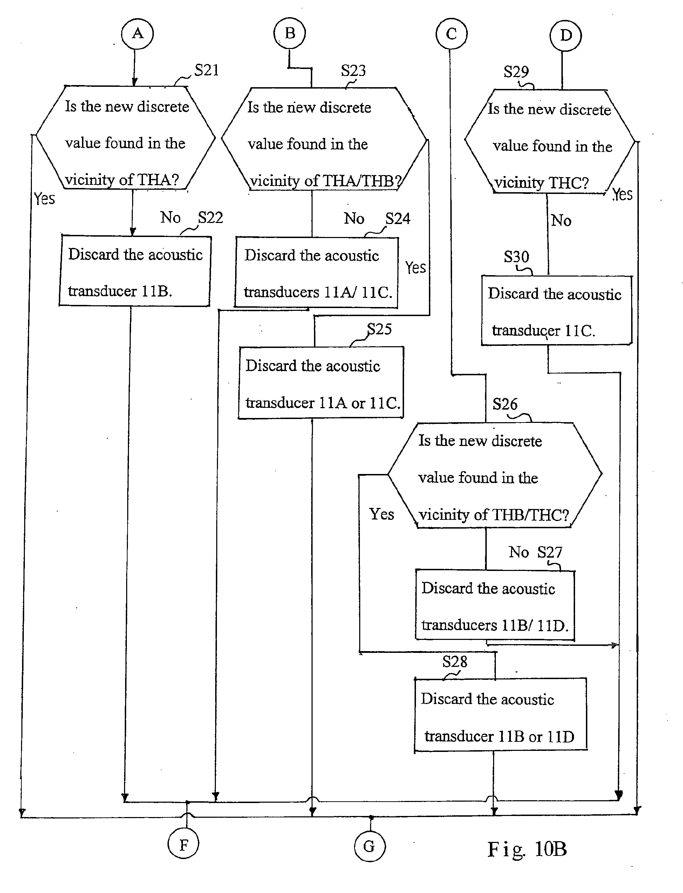

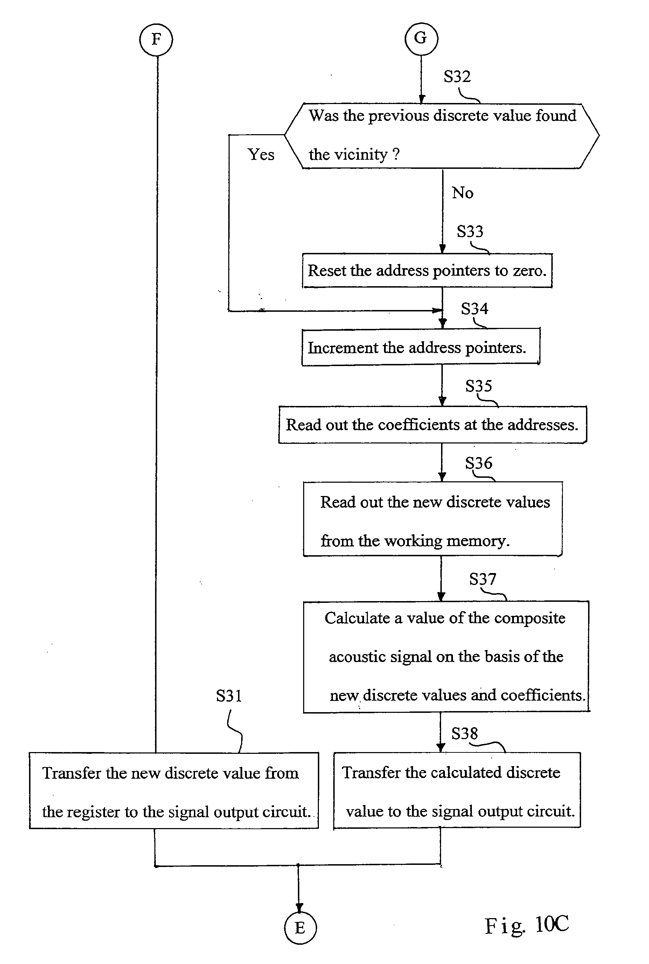

Figures 10A to 10C show a job sequence of the computer program. The computer program has a main routine and a subroutine. The main routine periodically branches into the subroutine through timer interruptions. Each of the timer interruptions takes place upon expiry of a predetermined time period. The timer interruption takes place at the predetermined time intervals approximately equal to the sampling intervals for the analog-to-digital conversion by means of the analog-to-digital converters 21.

When the silicon microphone is powered, the computer program starts to run on the microprocessor. The microprocessor firstly carries out a system initialization as by step S1 in figure 10A. While the microprocessor is initializing the system, predetermined memory locations in the working memory are assigned to new discrete values, and address pointers are defined at another memory location in the working memory. The address pointers are indicative of the addresses where the values of coefficients are stored. The value of coefficient on the plots S1 is read out from the address indicated by one of the address pointers, and the value of coefficient on the plots S2 is read out from the address indicated by the other address pointer. (See figure 9). The address pointers are incremented so that the value on plots S1 and value on plots S2 are respectively decreased and increased together with time. When the address pointers are incremented to "1", the address counters are indicative of the addresses where the values of coefficients at t1 are stored.

Upon completion of the system initialization, the microprocessor checks the working memory to see whether or not new discrete values are stored in the predetermined memory locations as by step S11.

While the answer at step S11 is being given negative "No", the microprocessor repeats the job at step S11, and waits for the change of answer at step S11. When new discrete values are stored in the predetermined memory locations, the answer at step S11 is changed to affirmative "Yes".

With the positive answer "Yes" at step S11, the microprocessor reads out the new discrete values from the working memory as by step S12, and normalizes the new discrete values of the digital acoustic signals DS1 to DS3 as by step S13. The normalization has been already described in conjunction with the function "Normalization" at the boxes 226aA, 226aB and 226aC in figure 7. The microprocessor stores the normalized values in the working memory as by step S14.

Subsequently, the microprocessor reads out the new discrete value A on the digital acoustic signal DS4 from the working memory as by step S15, and compares the new discrete value A with the critical values THA, THB and THC to see what range the new discrete value is fallen into as by step S16. The critical values THA, THB and THC and comparison have been already described in conjunction with the boxes 223a and 224.

When the new discrete value A is found in the range less than the critical value THA, the microprocessor temporarily selects the acoustic transducers 11A and 11B from the four as by step S17. When the new discrete value A is found in the range equal to the critical value THA and less than the critical value THB, the microprocessor temporarily selects the acoustic transducers 11A, 11B and 11C from the four as by step S18.

When the new discrete value A is found in the range equal to the critical value THB and less than the critical value THC, the microprocessor temporarily selects the acoustic transducers 11B, 11C and 11D from the four as by step S19. When the new discrete value A is found in the range equal to or greater than the critical value THC, the microprocessor temporarily selects the acoustic transducers 11C and 11D from the four as by step S20.

The acoustic transducers 11A and 11B are assumed to be selected at step S17. The microprocessor checks the new discrete value A to see whether or not the new discrete value A is fallen in the vicinity of the critical value THA as by step S21. If the new discrete value A is fallen in the vicinity of the critical value THA, the answer at step S21 is given affirmative "Yes", and the microprocessor proceeds to step S32. On the other hand, when the discrete value A is found to be outside of the vicinity of the critical value THA, the answer at step S21 is given negative "No", and the microprocessor proceeds to step S31.

The acoustic transducers 11A, 11B and 11C are assumed to be selected at step S18. The microprocessor checks the new discrete value A to see whether or not the new discrete value A is fallen in the vicinity of the critical value THA or THB as by step S23. If the new discrete value A is fallen in the vicinity of the critical value THA or THB, the answer at step S23 is given affirmative "Yes", and the microprocessor discards either acoustic transducer 11A or 11C as by step S25. In detail, when the new discrete value A is found in the vicinity of critical value THA, the microprocessor discards the acoustic transducer 11C. On the other hand, when the new discrete value A is found in the vicinity of critical value THC, the microprocessor discard the acoustic transducer 11A. However, if the new discrete value A is found outside of the vicinities of critical values THA and THB, the answer at step S23 is given negative "No", and the microprocessor discards both of the acoustic transducers 11A and 11C as by step S24. Upon completion of job at step S24, the microprocessor proceeds to step S31. On the other hand, when the microprocessor completes the job at step S25, the microprocessor proceeds to step S32.

The acoustic transducers 11B, 11C and 11D are assumed to be selected at step S19. The microprocessor checks the new discrete value A to see whether or not the new discrete value A is fallen in the vicinity of the critical value THB or THC as by step S26. If the new discrete value A is fallen in the vicinity of the critical value THB or THC, the answer at step S26 is given affirmative "Yes", and the microprocessor discards either acoustic transducer 11B or 11D as by step 528. In detail, when the new discrete value A is found in the vicinity of critical value THB, the microprocessor discards the acoustic transducer 11D. On the other hand, when the new discrete value A is found in the vicinity of critical value THC, the microprocessor discard the acoustic transducer 11B. However, if the new discrete value A is found outside of the vicinities of critical values THB and THC, the answer at step S26 is given negative "No", and the microprocessor discards both of the acoustic transducers 11B and 11D as by step S27. Upon completion of job at step S24, the microprocessor proceeds to step S31. On the other hand, when the microprocessor completes the job at step S28, the microprocessor proceeds to step S32.

The microprocessor is assumed to select the acoustic transducers 11C and 11D at step S20. The microprocessor checks the new discrete value A to see whether or not the new discrete value A is found in the vicinity of critical value THC as by step S29. If the new discrete value A is found in the vicinity THC, the answer at step S29 is given affirmative "Yes", and the microprocessor proceeds to step S32. On the other hand, if the new discrete value is found to be outside of the vicinity of critical value THC, the answer at step S29 is given negative "No", and the microprocessor discards the acoustic transducer 11C as by step S30. Upon completion of the job at step S30, the microprocessor proceeds to step S31. Thus, the microprocessor proceeds to step S31 on the condition that the new discrete value A is found to be outside of the vicinities of critical values THA, THB and THC, and proceeds to step S32 on the condition that the new discrete value A is found in the vicinity of either critical value THA, THB or THC.

When the new discrete value A is found to be outside of the vicinities of critical values THA, THB and THC, any cross fading is not required. For this reason, the microprocessor transfers the new discrete value from the working memory to the signal output circuit at step S31.

On the other hand, if the new discrete value A is found to be in the vicinity of either critical value THA, THB or THC, the microprocessor carries out the cross fading as follows.

First, the microprocessor checks the working memory to see whether or not the previous discrete value was fallen in the vicinity as by step S32. If the answer at step S32 is given negative "No", the microprocessor resets the address pointers to zero as by step S33, and increments the address pointers. When the address pointers are incremented from zero to "1", the address pointers are indicative of the addresses where the values of coefficients at t1 are stored.

On the other hand, when the previous discrete value was found in the vicinity, the addresses are to be incremented together with the lapse of time from t1. For this reason, the microprocessor proceeds to step S34, and increments the address pointers.

Thus, the values of coefficients are successively read out from the addresses in the nonvolatile memory as by step S35. The microprocessor reads out the new discrete values from the working memory as by step S36, and calculates a value of the composite acoustic signal S5 on the basis of the new discrete values and the coefficients as by step S37. Upon competition of the calculation, the microprocessor transfers the value of the composite acoustic signal to the signal output circuit as by step S38. The microprocessor returns from step S31 or S38 to step S11. Thus, the microprocessor reiterates the loop consisting of steps S11 to S38. When the acoustic transducers are to be changed, the acoustic transducers are overlapped with one another in the vicinities, and the values of composite acoustic signals are produced through the cross fading.

As will be understood from the flowchart shown in figures 10A to 10C, the functions "normalization", "composition control" and "composition" are realized through the execution of computer program.

The silicon microphone 1a of the present invention has plural acoustic transducers 11A to 11D different in sensitivity, and produces the composite acoustic signal S5 from the acoustic signals S1, S2, S3 and S4 through the composition. While the sound pressure is being relatively low, the composite acoustic signal S5 is produced from the acoustic signal S1, S2 or S3 output from the acoustic transducer 11A, 11B or 11C with relatively high sensitivity. When the discrete value indicative of the sound pressure is equal to or greater than the critical value THC of the acoustic signal S3, the composite acoustic signal S5 is produced from the acoustic signal S4 output from the acoustic transducer 11D with the lowest sensitivity. However, the acoustic transducer is responsive to the widest range of sound pressure. As a result, the silicon microphone 1a of the present invention achieves the linear sound-to-signal converting characteristics in wide sound pressure range without sacrifice of the sensitivity at the relatively low sound pressure.

When the acoustic transducer is changed, the silicon microphone 1a of the first embodiment carries out the cross fading on the pieces of sound pressure data output from the acoustic transducers on both sides of the critical value THA, THB or THC so that the composite acoustic signal S5 is free from undesirable noise. Since the sound pressure-to-electric signal characteristics are partially overlapped with one another, the silicon microphone 1a makes it possible to carry out the cross fading.

The pieces of sound pressure data from the acoustic transducers 11A, 11B and 11C are normalized with respect to the piece of sound pressure data output from the acoustic transducer 11D with the lowest sensitivity. The acoustic transducer exhibits the wide dynamic range is so that the optimum acoustic transducer or transducers are selected from the plural acoustic transducers.

The acoustic transducers 11A to 11D are integrated on the single substrate so that the fabrication process is simplified.

### Second Embodiment

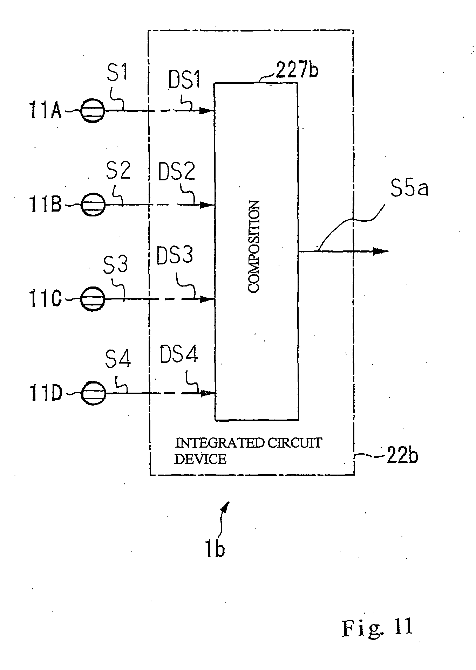

Turning to figure 11 of the drawings, another silicon microphone 1b embodying the present invention largely comprises plural acoustic transducers 11A, 11B, 11C and 11D and an integrated circuit device 22b. The acoustic transducers 11A to 11D are same as those of the first embodiment, and no further description is hereinafter incorporated for the sake of simplicity.

The integrated circuit device 22b is adapted to achieve a function, i.e., "composition 227b", through which the intermediate acoustic signals S1 to S4 compose a composite acoustic signal DS5a. For the composition 227b, the integrated circuit device 22b calculates a sum of values expressing the amplitude of the intermediate acoustic signals S1 to S4 or a square root of the sum of square values. In this instance, analog-to-digital converters and a microcomputer are integrated on a single semiconductor chip, and the following function is realized through an execution of a computer program.

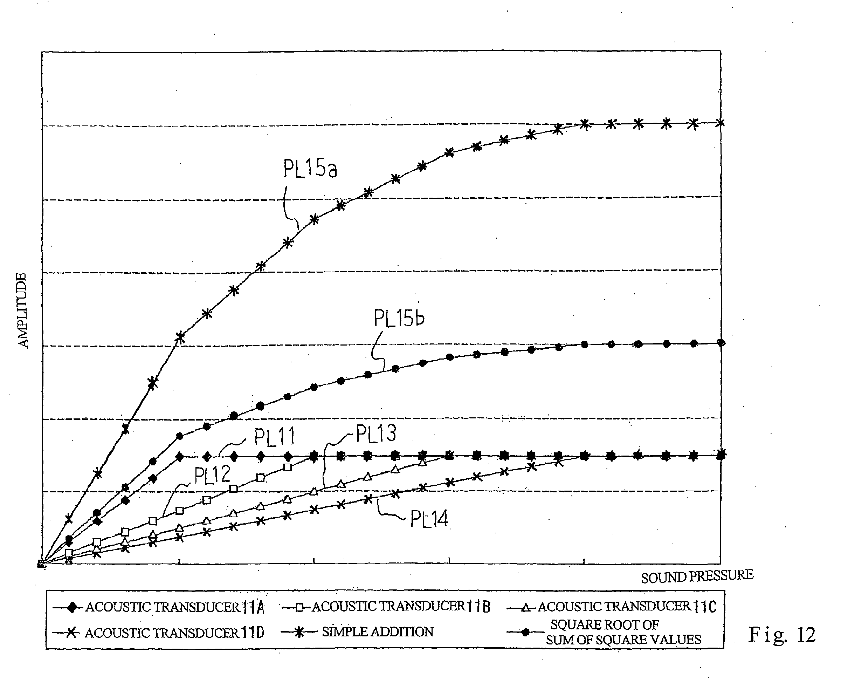

Figure 12 shows the function of the integrated circuit device 22b. PL11, PL12, PL13 and PL14 stand for relation between the sound pressure and the amplitude of intermediate acoustic signals S1, S2, S3 and S4. Although the actual intermediate acoustic signals S1 to S4 have proportional regions and non-proportional regions as shown in figure 8, the amplitude of intermediate acoustic signals shown in figure 12 is linearly increased until the saturated state for the sake of simplification.

While the analog-to-digital converters are periodically outputting the discrete values on the plots PL11 to PL14 to the microcomputer, the microcomputer fetches the discrete values in synchronism with the analog-to-digital conversions, and temporarily stores the discrete values in an internal working memory. The discrete values are sequentially read out from the internal working memory, and are added to one another. As a result, the sum of discrete values is left in an internal register. The sum is output from the microcomputer as indicated by plots PL15a.

Otherwise, the discrete values are squared, and the square values are added to one another. A value of square root is extracted from the sum of square values. The square root of the sum of square values is output from the microcomputer as indicated by plots PL15b.

Comparing plots PL11 to PL14 with one another, it is understood that the amplitude of intermediate acoustic signals S1 to S4 at a certain sound pressure is increased together with the sensitivity. The larger the sensitivity is, the higher the amplitude is. The discrete values on the plots PL11 occupy a substantial part of the sum on plots PL15a and a substantial part of the square root of the sum of square values on plots PL15b until the plots PL11 is saturated. After the saturation of plots PL11, the discrete values on plots PL12 is more influential on the sum and the square root of sum of square values than the discrete values on the other plots PL11, PL13 and PL14 until the plots PL12 is saturated. However, the sum and the square root of sum of square values are increased together with the discrete values on the plots PL4 after the saturation of plots PL13. Thus, while a relatively low sound pressure is being input into the silicon microphone, the acoustic transducer with a relatively large sensitivity is more influential on the sum and the square root of sum of square values than the acoustic transducer with a relatively small sensitivity so that the composite acoustic signal DS5a is produced under the condition of a relatively large sensitivity. Although the influence of the acoustic transducers with relatively large sensitivity is reduced together with the increase of sound pressure, the sum and the square root of sum of square values are increased until the plots PL14 is saturated. In other words, the plots PL15a and PL15b are not saturated before the plots PL14 is saturated. Thus, the silicon microphone is responsive to the wide sound pressure range without sacrifice of the sensitivity in the relatively low sound pressure region.

The addition of discrete values or the calculation of square root of sum of square values is desirable, because the value due to random noise is less weighed in the sum or the square root of sum of square values.

### Third Embodiment

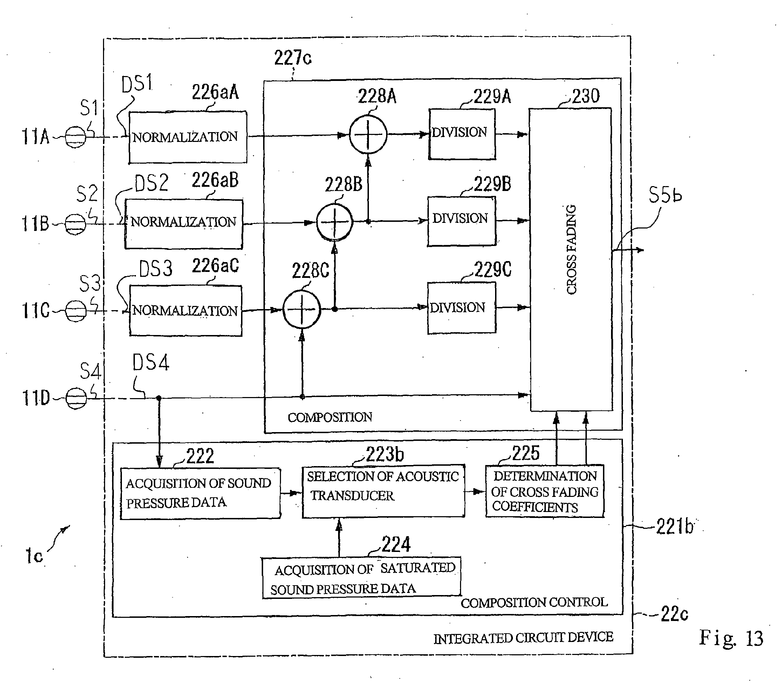

Turning to figure 13 of the drawings, yet another silicon microphone 1c embodying the present invention largely comprises plural acoustic transducers 11A to 11D and an integrated circuit device 22c. The acoustic transducers 11A to 11D are similar to those of the first embodiment, and, for this reason, are not hereinafter detailed. Boxes 221b, 222, 223b, 224, 225, 226aA to 226aC, 227c, 229A to 229C and 230 and circles 228A to 228C stand for functions of the integrated circuit device 22c.

The normalization 226aA, 226aB and 226aC are similar to those of the first embodiment, and the composition 227a and composition control 221a are replaced with a composition 227c and composition control 221b, respectively. For this reason, description is focused on the composition 227c and composition control 221b.

The composition control 221b is broken down into sub-functions of "acquisition of sound pressure data 222", "selection of acoustic transducer 223b", "acquisition of saturated sound pressure data 224" and "determination of cross fading coefficients 225". The sub-functions of "acquisition of sound pressure data 222", "acquisition of saturated sound pressure data 224" and "determination of cross fading coefficients 225" are similar to those of the first embodiment, and no further description is hereinafter incorporated for avoiding repetition.

When the current discrete value A is determined through the acquisition of sound pressure data, the critical values THA, THB and THC, which are shown in figure 8, are transferred through the acquisition of saturated sound pressure data 224 to the selection of acoustic transducer 223b, and the current discrete value is compared with the critical values THA, THB and THC for selecting one of or more than one of the acoustic transducers 11A to 11D. When the current discrete value A is less than the critical value THA, i.e., A < THA, all of the acoustic transducers 11A to 11D are selected through the selection of acoustic transducer 223b. If the current discrete value A is equal to or greater than the critical value THA and less than the critical value THB, i.e., THA ≦ A < THB, the acoustic transducers 11B, 11C and 11D are selected from the four. If the current discrete value A is equal to or greater than the critical value THB and less than the critical value THC, i.e., THB ≦ A < THC, the acoustic transducers 11C and 11D are selected from the four. If the current discrete value A is greater than the critical value THC, i.e., THC ≦ A, only the acoustic transducer 11D is selected from the four.

The function "composition" is broken down into sub-functions "addition" 228A, 228B and 228C, "division" 229A, 229B and 229C and "cross fading 230". The discrete value on the digital acoustic signal DS4 is added to the discrete value on the digital acoustic signal DS3 through the sub-function 228C, and the discrete value on the digital acoustic signal DS2 is added to the sum of the discrete values on the digital acoustic signals DS4 and DS3 through the sub-function 228B. The discrete value on the digital acoustic signal DS1 is added to the sum of the discrete values on the digital acoustic signals DS4, DS3 and DS2 through the sub-function 228A. The sub-functions 228A, 228B and 228C are selectively realized depending upon the acoustic transducers selected through the sub-function 223b.

The sum of discrete values is divided by the number of discrete values added to one another through the sub-function 229A, 229B or 229C. Although the quotient are per se output from the integrated circuit device 22d, the quotients are subjected to the cross fading 230 on the condition that the current discrete value A is fallen in the vicinities of critical values THA, THB and THC. The cross fading 230 is similar to that described in conjunction with the composition 227a, and detailed description is omitted for avoiding repetition.

While the sound waves being found in the small sound pressure region, the composite acoustic signal S5b is produced from the intermediate acoustic signal S1 of the acoustic transducer with a high sensitivity. This is because of the fact that the acoustic signal S1 has desirable influence on the composite acoustic signal S5b, which is produced from the acoustic signals S1 to S4. The acoustic transducers 11A to 11D are selectively used for producing the composite acoustic signal S5b in the sound pressure region between PA and PC. However, when the sound waves have a value of sound pressure greater than the saturated value PC, the composite acoustic signal is produced from the intermediate acoustic signal S4 of the acoustic transducer 11D with the widest dynamic range.

As will be understood from the foregoing description, the silicon microphone of the third embodiment is responsive to a wide sound pressure range without sacrifice of a high sensitivity in the small sound pressure region.

Since the addition 228A, 228B and 228C is followed by the division 229A, 229B or 229C, the composite acoustic signal S5b is varied in a relatively narrow numerical range so that the composite acoustic signal S5b is easy to be processed in an application device.

Random noise is reduced through the addition of plural discrete values.

The cross fading makes noise eliminated from the composite acoustic signal S5b.

### Fourth Embodiment

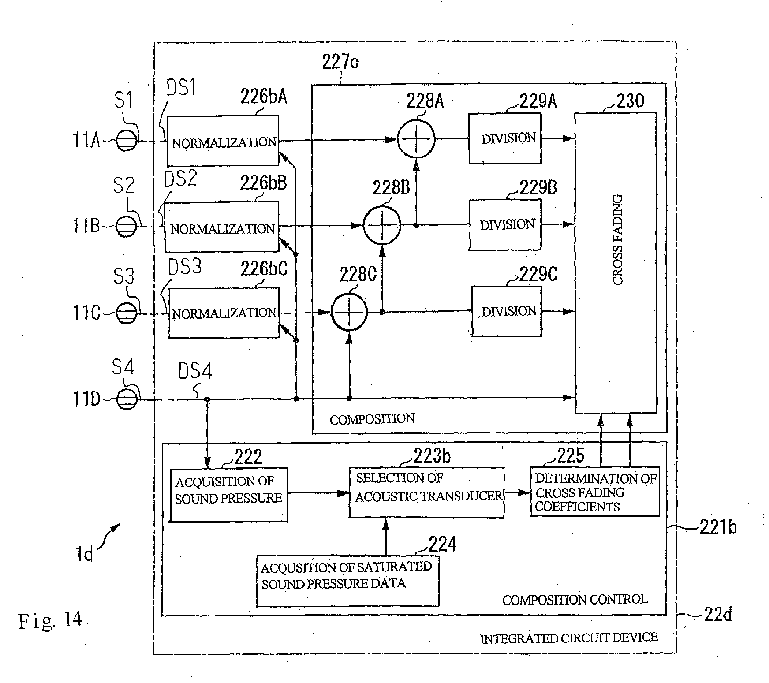

Figure 14 shows the function of still another silicon microphone 1d embodying the present invention. Still another silicon microphone 1d embodying the present invention largely comprises plural acoustic transducers 11A to 11D and an integrated circuit device 22d. The acoustic transducers 11A to 11D are similar to those of the first embodiment, and, for this reason, are not hereinafter detailed. Boxes 221b, 222, 223b, 224, 225, 226bA to 226bC, 227c, 229A to 229C and 230 and circles 228A to 228C stand for functions of the integrated circuit device 22d.

The composition 227c and composition control 221b are similar to those of the third embodiment, and the normalization 226aA, 226aB and 226aC are replaced with normalization 226bA, 226bB and 226bC. For this reason, description is focused on the normalization 226bA to 226bC.

Although the discrete values of digital acoustic signals DS1, DS2 and DS3 are amplified by the fixed values of ratios SD/ SA, SD/ SB and SD/ SC in the normalization 226aA, 226aB and 226aC, the ratio SD/ SA, SD/ SB and SD/ SC are variable in the normalization 226bA, 226bB and 226bC.

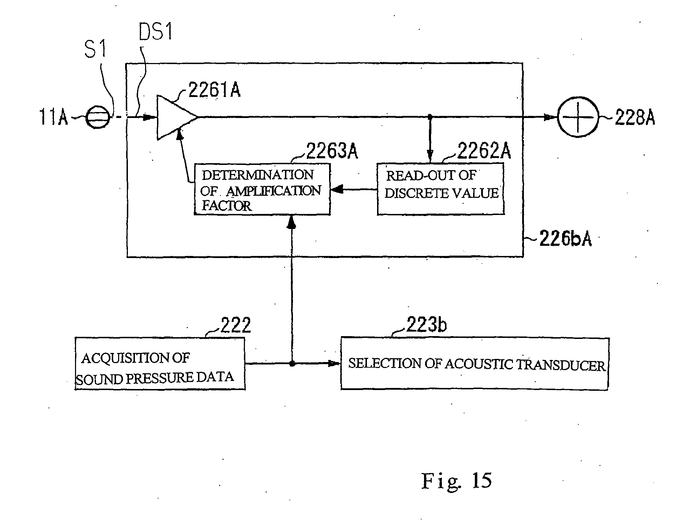

In detail, figure 15 shows the function of normalization 226bA. The other normalization 226bB and 226bC are identical in function with the normalization 226bA. The function of normalization 226bA is broken down into amplication 2261A, determination of the discrete value of digital acoustic signal 2262A and determination of the amplification factor 2263A.

The amplification factor is determined as follows. The current discrete value of digital acoustic signal DS4 is relayed from the sub-function of "acquisition of sound pressure data 222" to the sub-function of "determination of amplification factor 2263A", and the normalized discrete value of digital acoustic signal DS1 is relayed from the sub-function "read-out of discrete value 2262A" to the sub-function of "determination of amplification factor 2263A". The ratio SD/ SA is amplified by the gain, i.e., ratio DDS4/ DDS1 through the sub-function of "determination of amplification factor 2263A", where DDS4 and DDS1 are representative of the current discrete value of digital acoustic signal DS4 and the normalized discrete value of digital acoustic signal DS1. The product (SD/ SA × DDS4/ DDS1) is supplied from the sub-function "determination of amplification factor 2263A" to the sub-function "amplification 2261A" as the amplification factor. The discrete value of digital acoustic signal DS1 is amplified by the amplification factor (SD/ SA × DDS4/ DDS1) through the sub-function "amplification 2261A", and the product (DDS1 × (SD/ SA × DDS4/ DDS1)) is supplied from the sub-function of "amplification 2261A" to the sub-function "addition 228A".

As will be understood from the foregoing description, the silicon microphone 1d is responsive to the sound waves in the wide sound pressure range without sacrifice of high sensitivity in the small sound pressure region as similar to the first to third embodiments.

Moreover, the amplification factor is corrected through the amplification between the ratio (SD/ SA) and the ratio (DDS4/ DDS1). The ratio (SD/SA) is the correction factor due to the difference in sensitivity between the acoustic transducer 11D and the acoustic transducer 11A, and the ratio (DDS4/ DDS1) is another correction factor due to the difference in current sound pressure represented by the digital acoustic signals DS4 and DS1. Thus, the discrete values of digital acoustic signals DS1, DS2 and DS3 are exactly normalized with respect to the discrete value of digital acoustic signal DS4.

### Fifth Embodiment

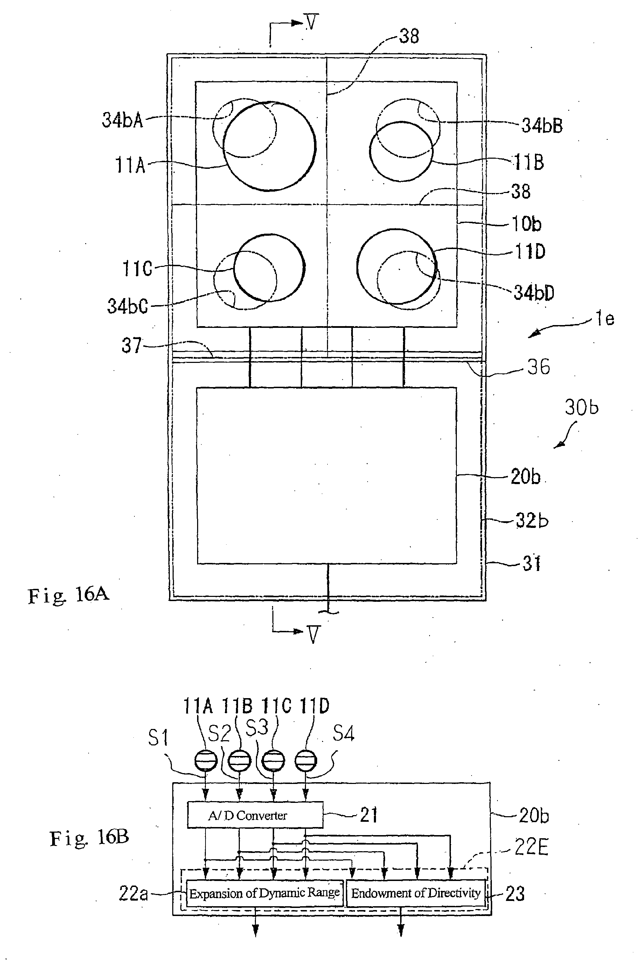

Turning to figures 16A and 16B of the drawings, yet another silicon microphone 1e largely comprises a silicon microphone device 10b, an integrated circuit device 20b and a package 30b. The silicon microphone device 10b has plural acoustic transducers 11A, 11B, 11C and 11D as similar to the silicon microphone device 10a of the first embodiment, and sound waves are concurrently converted to intermediate acoustic signals S1, S2, S3 and S4 by means of the acoustic transducers 11A to 11D. The intermediate acoustic signals S1 to S4 are supplied from the silicon microphone device 10b to the integrated circuit device 20b, and are subjected to a predetermined signal processing in the integrated circuit device 20b. A composite acoustic signal is produced through the predetermined signal processing on the basis of the intermediate acoustic signals S1 to S4, and is output from the silicon microphone 1e.

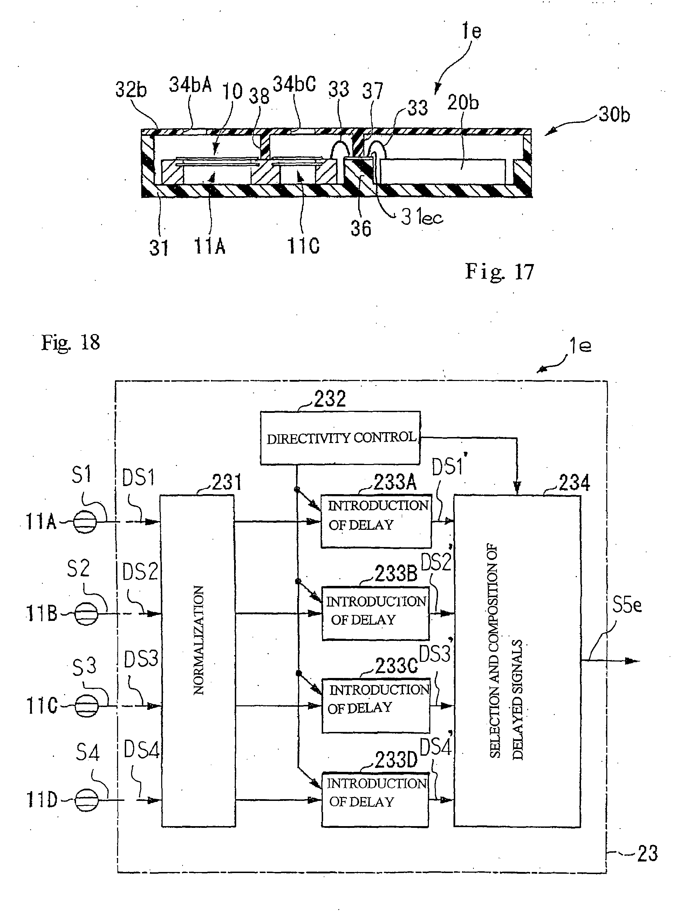

Although the single sound hole 34a is formed in the package 30a for all the acoustic converters 11A to 11D, the inner space of package 30b is divided into plural sub-spaces by means of partition walls 36, 37 and 38 as shown in figure 17. The package 30b is broken down into a circuit board 31 and a lid 32b. The partition wall 36 upwardly projects from the circuit board 31, and extends in the lateral direction as indicated by dots-and-dash line in figure 16A. The partition wall 37 downwardly projects from the inner surface of lid 32b, and is held in contact with the upper surface of the partition wall 36. Thus, the inner space of the package 30b is divided into two sub-spaces, and the silicon microphone device 10 and integrated circuit device 20b are assigned to the sub-spaces, respectively. The acoustic transducers 11A to 11D are connected to a conductive pattern 31ec on the circuit board 31 through pieces of bonding wire 33, and the conductive pattern 31ec is further connected to pads on the integrated circuit device 20b through other pieces of bonding wire 33.

The partition walls 38 downwardly project from the inner surface of the lid 32b over the silicon microphone device 10, and cross each other at right angle. The lower surfaces of partition walls 38 are held in contact with the upper surface of the silicon microphone device 10. As a result, the sub-space, which is assigned to the silicon microphone device 10, is further divided into four compartments. Thus, each of the compartments is isolated from the other compartments by means of the partition walls 38. The four compartments are respectively assigned to the acoustic transducers 11A to 11D. Although the four acoustic transducers 11A to 11D are integrated on the single silicon substrate, more than one silicon substrate may be used for the silicon microphone device 10b.

Sound holes 34bA, 34bB, 34bC and 34bD are formed in the lid 32b, and are slightly offset the four acoustic transducers 11A to 11D in a direction spaced from the center of partition walls 38, respectively. The reason for the offset arrangement is that a time delay is introduced among the arrivals of sound waves at the acoustic transducers 11A to 11D. The four compartments are open to the atmosphere through the four sound holes 34bA to 34bD, respectively. The sound waves pass through the four sound holes 34bA to 34bD, and reach the acoustic transducers 11A to 11D. The other features of package 30b are similar to the corresponding features of package 30a, and nor further description is hereinafter incorporated for the sake of simplicity.

The integrated circuit device 20b includes analog-to-digital converters 21 and an information processing system 22E as shown in figure 16B. A computer program runs on a microprocessor of the information processing system 22E, and realizes a function of "expansion of dynamic range 22a" and another function of "endowment of directivity 23". The function of "expansion of dynamic range 22a" is similar to the function of the integrated circuit device described in conjunction with the first embodiment, second embodiment, third embodiment or fourth embodiment. The function of "endowment of directivity 23" is hereinafter described in detail.

The function of "endowment of directivity 23" is broken down into sub-functions of "normalization 231", "directivity control 232", "introduction of delay 233A, 233B, 233C and 233D" and "selection and composition of delayed signals 234" as shown in figure 18. The function 23 endows the silicon microphone 1e with the directivity so that the amplitude of composite acoustic signal S5 is varied depending upon the direction of a source of sound waves. The physically separated arrangement of acoustic transducers 11A to 11D makes it possible to endow the silicon microphone 1e with the directivity.

The endowment of directivity is achieved by introducing delays into the digital acoustic signals DS1 to DS4. In detail, the digital acoustic signals DS1 to DS3 are firstly normalized with respect to the digital acoustic signal DS4 as if the acoustic transducers 11A, 11B and 11C have the sensitivity equal to the sensitivity of the acoustic transducer 11D. The sub-function of "normalization 231" is similar to the sub-function 226aA/ 226aB/ 226aC or 226bA/ 226bB/ 226bC, and, for this reason, no further description is hereinafter incorporated for avoiding repetition.

The acoustic transducers, which are to participate the endowment of directivity, are selected from the four acoustic transducers 11A to 11D through the sub-function of "directivity control 232", and the direction of directivity is determined also through the sub-function of "directivity control 232". Thereafter, the amount of delay to be introduced into the selected acoustic transducers is determined on the basis of the direction of directivity through the sub-function of "directivity control 232".

The amount of delay is relayed from the sub-function of "directivity control 232" to the sub-function of "introduction of delay 233A, 233B, 233C and 233D". The normalized discrete values are relayed from the sub-function of "normalization 231" to the selected sub-functions of "introduction of delay 233A, 233B, 233C and 233D", and the amount of delay is introduced into the propagation of each of the normalized discrete values. Thus, digital delayed acoustic signals DS1', DS2', DS3' and DS4' are relayed from the sub-function "introduction of delay 233A, 233B, 233C and 233D" to the sub-function of "selection and composition of delayed signals 234".

Since the sub-function "directivity control" informs the sub-function of "selection and composition of delayed signals 234" of the selected acoustic transducers, a composite acoustic signal S5e is produced from the selected ones of the digital delayed acoustic signals DS1' to DS4' through the sub-function of "selection and composition of delayed signals 234". The composite acoustic signal S5e is endowed with the directivity through the beam steering or null steering. The beam steering makes sound waves in a particular direction emphasized, and the null steering makes sound waves in a particular direction reduced.

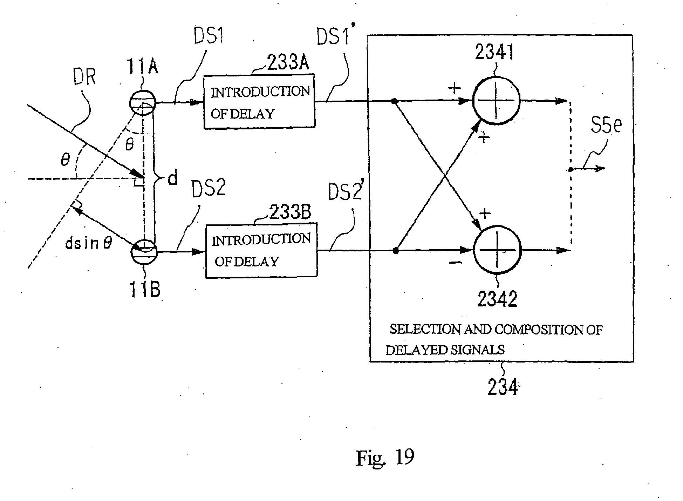

In detail, figure 19 shows the concept of endowment of directivity on the assumption that the acoustic transducers 11A and 11B are selected from the four acoustic transducers 11A to 11D. The center of the diaphragm 15 of acoustic transducer 11A is spaced from the center of the diaphragm 15 of other acoustic transducer 11B by distance "d". The sound waves are assumed to be propagated on a plane, i.e., plane waves for the sake of simplification. The plane waves are propagated from a sound source to the acoustic transducers 11A and 11B in direction DR. When the plane waves arrives at the diaphragm 15 of acoustic transducer 11A, there remains distance (d sin θ) until the diaphragm 15 of acoustic transducer 11B. The delay time is expressed as (d sin θ)/ c where c is the acoustic velocity. Thus, the excitation of diaphragm 15 of acoustic transducer 11B is delayed from the excitation of diaphragm 15 of acoustic transducer 11A by (d sin θ )/ c.

When the amount of delay is adjusted to (d sin θ)/ c for the sub-function of "introduction of delay 233A", the delay time between the acoustic transducer 11A and the acoustic transducer 11B is cancelled. As a result, the introduction of delay (d sin θ )/ c makes the digital delayed acoustic signals DS1' and DS2' express the plane waves propagated in the direction DR as if the plane waves simultaneously arrive at both of the acoustic transducers 11A and 11B. Of course, the introduction of delay (d sin θ)/ c is proper to only the plane waves in the direction DR. There remains delay time in the propagation of plane waves in a direction different from the direction DR, or the delay time is increased for the plane waves propagated in other directions when θ is around 90 degrees.

The sub-function "selection and composition of delayed signals" is equivalent to sub-function "addition" and/ or "substitution". When the composite acoustic signal S5e is endowed with the directivity in the direction DR through the beam steering, the digital delayed acoustic signal DS2' is added to the digital delayed acoustic signal DS1'. As a result, the discrete value of composite acoustic signal S5e is twice as large as the discrete value of digital acoustic signal DS1. On the other hand, the discrete values of composite acoustic signal S5e, which express sound waves propagated from directions different from the direction DR, are less than the discrete value of composite acoustic signal S5e expressing the sound waves propagated in the direction DR due to the actual delay time different from the delay time (d sin *θ* )/ c. Thus, the sound waves propagated in the direction DR are emphasized through the beam steering.

On the other hand, when the composite acoustic signal S5e is endowed with the directivity through the null steering, the sub-function "subtraction" is used for the endowment of directivity. The discrete value of digital delayed acoustic signal DS2' is subtracted from the discrete value of digital delayed acoustic signal DS1' so that the discrete value of composite acoustic signal S5e is minimized to zero. On the other hand, the discrete value of composite acoustic signal S5e is greater than zero due to the remaining delay time. In an extreme case, the discrete value of composite acoustic signal S5e is greater than the discrete value of digital delayed acoustic signal DS1'. Thus, the sound waves in the direction DR are emphasized through the null steering.

Another set of acoustic transducers such as, for example, the acoustic transducers 11C and 11D may be selected from the four through the sub-function "directivity control 232".

As will be understood from the foregoing description, the silicon microphone makes it possible to respond to the sound waves in the wide sound pressure range without sacrifice of the high sensitivity in the small sound pressure region as similar to the first to fourth embodiments.

Moreover, the acoustic converters 11A to 11D are accommodated in the compartments physically separated from one another, and the compartments are open to the atmosphere through individual sound holes 34bA, 34bB, 34bC and 34bD, respectively. For this reason, the sound waves give rise to the excitation of diaphragms 15 at different times, and the sub-function "endowment of directivity" makes it possible to emphasize the sound waves propagated from a particular direction. Thus, the silicon microphone 1e produces the directive composite acoustic signal S5e from the intermediate acoustic signals S1 to S4.

Furthermore, the acoustic transducers 11A, 11B, 11C and 11D make the silicon microphone compact. It is expected to supersede the prior art bulky directional microphone with the compact directional microphone of the present invention.

Although the acoustic transducers 11A, 11B, 11C and 11D are different in sensitivity from one another, it is possible to form a semiconductor directional microphone from plural acoustic transducers approximately equal in sensitivity to one another.

### Sixth Embodiment

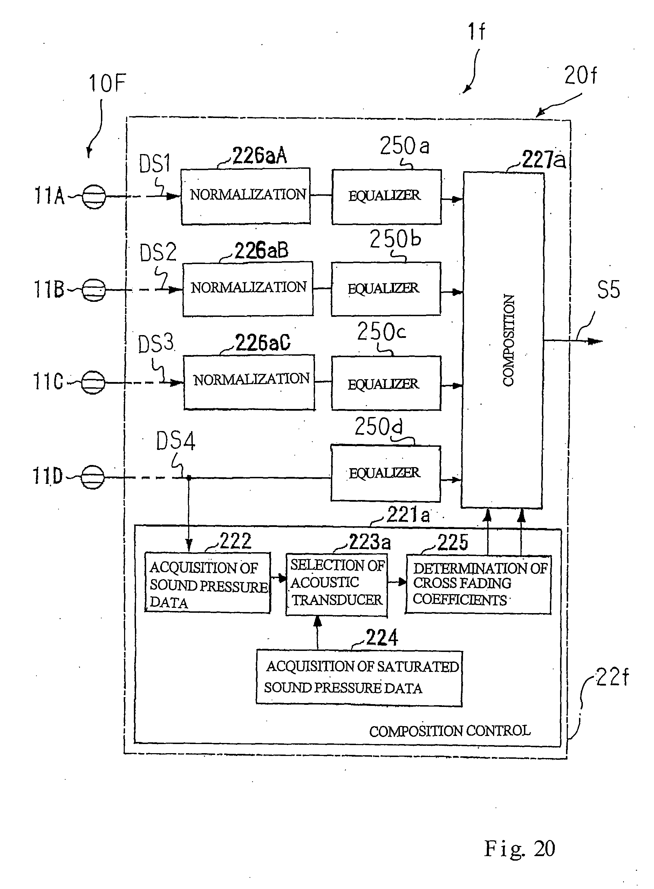

Referring to figures 20 of the drawings, still another silicon microphone 1f embodying the present invention largely comprises largely comprises a silicon microphone device 10F, an integrated circuit device 20f and a package (not shown). The silicon microphone device 10F includes plural acoustic transducers 11A, 11B, 11C and 11D, which are similar in structure to those of the silicon microphone device 10. For this reason, detailed description is not made on the acoustic transducers 11A, 11B, 11C and 11D for the sake of simplicity.

The integrated circuit device 20f includes analog-to-digital converters (not shown) and an information processing system 22f. The information processing system 22f is similar in system configuration to the information processing system 22a except for equalizers 250a, 250b, 250c and 250d. For this reason, description is focused on the equalizers 250a to 250d for avoiding repetition.

In general, an acoustic transducer with low sensitivity is proper to conversion from loud sound to an electric signal, and exhibits good sound-to-signal converting characteristics for low-frequency sound components rather than high-frequency sound components. On the other hand, when sound is produced at small loudness, an acoustic transducer with high sensitivity is well responsive to the sound, and exhibits good sensitivity to high-frequency sound components rather than low-frequency sound components. This phenomenon is observed among the acoustic transducers 11A, 11B, 11C and 11D.

As described in conjunction with the silicon microphone 1a, the composite acoustic signal S5 is produced from selected one or two of the intermediate acoustic signals S1 to S4 depending upon the loudness of sound. When faint sound reaches the silicon microphone 1a, the information processing system 22a selects the acoustic transducer 11A or 11B. The selected acoustic transducer 11A or 11B tends to emphasize the high frequency components of faint sound. On the other hand, when loud sound is input to the silicon microphone 1a, the information processing system 22a selects the acoustic transducer 11D or 11C. The selected transducer 11D or 11C tends to emphasize the low frequency components of loud sound. When the composite acoustic signal S5 is converted to sound, users feel the reproduced sound slightly different from the original sound.

In order to improve the quality of reproduced sound, the equalizers 250a to 250c are connected between the normalizations 226aA to 226aC to the composition 227a, and the equalizer 250d is connected between the analog-to-digital converter (not shown) and the composition 227a. Each of the equalizers 250a to 250d is responsive to plural frequency bands of intermediate acoustic signal DS1, DS2, DS3 or DS4, and the signal components of intermediate acoustic signal are amplified with different values of gain. The different values of gain are memorized in application goods such as, for example, mobile telephone, as default values. The users may change the gain from the default values to their own values through a man-machine interface of the application goods.

In this instance, the equalizer 250a has a larger value of gain on low frequency band components such as 100 Hz to 500 Hz rather than the value of gain on high frequency band components, and the equalizer 250d has a larger value of gain on high frequency band components such as 1.5 kHz to 2 kHz of voice and 2 kHz to 10 kHz of musical instrument sound rather than the value of gain on low frequency band components. Thus, the equalizers 250a to 250d compensate the distortion due to the sound-to-signal converting characteristics of acoustic transducers 250a to 250d.

Another function of equalizers 250a to 250d is to make the plural frequency band components output from the audio transducers 11A to 11D equalized or balanced at the composition 227a through regulation of frequency band components. In the regulation, a certain value of sound pressure serves as a "reference" common to the acoustic transducers 11A to 11D. A mean value of sound pressure in a predetermined frequency band of voice may serve as the reference for the acoustic transducers 11A to 11D. The predetermined frequency band for voice may be 500 Hz to 10 kHz. Otherwise, a value of sound pressure at 1 kHz may serve as the reference.

After the regulation, the intermediate acoustic signals DS1 to DS4 are supplied from the equalizers 250a to 250d to the composition 227a, and the composition 227a produces the composite acoustic signal S5 from the regulated intermediate acoustic signals DS1 to DS4. The regulation of frequency band components is desirable, because the composition 227a keeps the composite acoustic signal S5 stable at the change from one of the intermediate acoustic signals DS1 to DS4 to another intermediate acoustic signal. Thus, the users feel the reproduced sound natural at the change of acoustic transducers 11A to 11D by virtue of the regulation of frequency band components among the intermediate acoustic signals DS1 to DS4.

Although particular embodiments of the present invention have been shown and described, it will be apparent to those skilled in the art that various changes and modifications may be made without departing from the spirit and scope of the present invention.

The silicon microphone device 10 and integrated circuit device 20a may be mounted on a multi-layer board. In this instance, the conductive pads are connected to a multi-layer interconnection of the multi-layer board. A conductive layer of the multi-layer board and a lid serve as a shield structure.

The area of diaphragms 15 is narrowed in the order of acoustic transducers 11A, 11B, 11C, 11D so as to make the sensitivity SA to SD of acoustic transducers 11A to 11D different in the above- described embodiment. However, other design factors, which have influences on the amplitude of vibrations, make the sensitivity SA to SD different. For this reason, the diaphragms 15 may be different in flexural rigidity, i.e., the geometrical moment of inertia and/ or material from one another. The thicker the diaphragm is, the lower the sensitivity is. The larger the stress in diaphragms is, the lower the sensitivity is.

Although the integrated circuit device 22b realizes the composition through the computer program, the microcomputer and computer program may be replaced with a wired-logic circuit. For example, the digital acoustic signals DS1 to DS4 may be supplied to adders synchronized with one another by means of a timing control signal from a frequency multiplier. A DSP(Digital Signal Processor) is available for the information processing system.

The normalization 226aA to 226aC may be carried out on the digital acoustic signals DS1 to DS4 before the function 227b. In this instance, the normalization makes it possible to enhance the fidelity of the composite acoustic signal S5a.

The sum and the square root of sum of square values do not set any limit to the technical scope of the present invention. In case where an integrated circuit calculates the square root of sum of square values, the polarity of the intermediate acoustic signals S1 to S4 is eliminated from the square values. In order to keep the piece of polarity data in the composite acoustic signal PL15b, the integrated circuit device may determine the composite acoustic signal through the following steps.
1. Keep pieces of polarity data indicative of the positive sign or negative sign added to the discrete values of the digital acoustic signals DS1 to DS4 in memory locations of the working memory:
2. Square the positive discrete values and/ or negative discrete values:
3. Add the piece of polarity data to the square values:
4. Add the positive square values and/ or negative square values to one another:
5. Keep the piece of polarity data of the sum of square values in a memory location of the working memory:
6. Find the square root of the absolute value of the sum: and
7. Add the piece of polarity data to the square root.

Silicon does not set any limit to the technical scope of the present invention. Term "silicon" is a typical example of the semiconductor material. Another sort of semiconductor microphone device may form a part of a semiconductor microphone of the present invention.

The optical sound waves-to-electric signal converters on the gallium-arsenide substrates disclosed in Japan Patent Application laid-open No. 2001-169395 may form a semiconductor microphone together with the integrated circuit device 20a or 20b. Although the optical sound waves-to-electric signal converters are used for expansion of bandwidth, it is possible to redesign the vibratory plates for different values of sensitivity. The acoustic transducers 11A to 11D are replaced with the optical sound waves-to-electric signal converters with the redesigned vibratory plates.

Two acoustic transducers, three acoustic transducers or more than four acoustic transducers may be connected in parallel to the integrated circuit device.

The silicon microphone devices 10 and 10A/ 10C may be housed in a package different from a package for the integrated circuit device 20a/ 20b.

The sub-function of "cross-fading" is not an indispensable feature of the present invention. The discrete values of digital acoustic signal may be simply formed in the composite acoustic signal without the cross fading. An interpolation may be employed in the vicinity of the critical values THA, THB and THC.

A single equalizer may be shared among more than one acoustic transducers 11A to 11D. In this instance, the single equalizer is accompanied with a selector, and a control signal is supplied from the selection of acoustic transducer 223a to the selector. When the selection of acoustic transducer 223a steers the selector from one of the intermediate acoustic signals to another one, the single equalizer carries out the compensation of regulation for the newly selected intermediate acoustic signal. The single equalizer makes the system configuration simple, and the manufacturer reduces the production cost.

The component parts and jobs described in the embodiments are correlated with claim languages as follows.

The packages 30a; 30Aa; 30b serve as "a housing". The silicon microphones 1a, 1Aa, 1b, 1c, 1d and 1e serve as a "semiconductor microphone", and the integrated circuit devices 20a, 20Aa and 20b and computer programs running on the microprocessors of the integrated circuit devices 20a and 20b as a whole constitute a "signal processor". The intermediate signals S1, S2, S3 and S4 and digital intermediate acoustic signals DS1, DS2, DS3 and DS4 serve as "intermediate acoustic signals", and the composite acoustic signals S5, S5a, S5b and S5e are corresponding to a "composite acoustic signal". One of or two of the digital acoustic signals DS1 to DS4, which are selected through the sub-function of "selection of acoustic transducer 223a/ 223b" are "optimum acoustic signals". "A current value of the sound pressure of said sound waves" is obtained through the sub-function of "acquisition of sound pressure data 222.

The information processing system 22a/ 22b/ 22c/ 22d/ 22E and a part of the computer program realizing the sub-functions of "acquisition of sound pressure data 222", "selection of acoustic transducers 223a/ 223b", "acquisition of saturated sound pressure data 224" and "determination of cross fading coefficients 225" as a whole constitute "a composition controller", and the information processing system 22a/ 22b/ 22c/ 22d/ 22E and another part of the computer program realizing the sub-functions of "normalization 226aA/ 226aB/ 226aC or 226bA/ 226bB/ 226bC" and "composition/ cross fading 227a/ 227b/ 230" as a whole constitute a "composer"

The information processing system 22a/ 22b/ 22c/ 22d/ 22E and a part of the computer program realizing the sub-functions of "acquisition of sound pressure data 222", "selection of acoustic transducers 223a/ 223b" and "acquisition of saturated sound pressure data 224" as a whole constitute a "selector", and the information processing system 22a/ 22b/ 22c/ 22d/ 22E and a part of the computer program realizing the sub-function "determination of cross fading coefficients 225" as a whole constitute a "determiner". The cross fading coefficients are "parameters".

The information processing system 22a/ 22b/ 22c/ 22d/ 22E and a part of the computer program realizing the sub-function of "normalization 226aA/226aB/ 226aC or 226bA/ 226bB/ 226bC" as a whole constitute a "normalization unit", and the information processing system 22a/ 22b/ 22c/ 22d/ 22E and another part of the computer program realizing the sub-function of "composition/ cross fading 227a/ 227b/ 230" as a whole constitute a "merging unit".

The information processing system 22E and a part of the computer program realizing the sub-functions of "directivity control 232", "introduction of delay 233A, 233B, 233C and 233D" and "selection and composition of delayed signals 234" as a whole constitute an "endower". The information processing system 22E and a part of the computer program realizing the sub-functions of "directivity control 232" as a whole constitute a "directivity control unit", and the information processing system 22E and another part of the computer program realizing the sub-functions of "introduction of delay 233A, 233B, 233C and 233D" as a whole constitute a "delay unit". The information processing system 22E and yet another part of the computer program realizing the sub-functions of "selection and composition of delayed signals 234" as a whole constitute an "emphasizing unit". The direction "DR" is corresponding to a "particular direction".

The back plate 16 serves as a "stationary electrode", and the diaphragm 15 serves as "vibratory electrode".

## Claims

1. A semiconductor microphone (1a; 1Aa; 1b; 1c; 1d; 1e; 1f) connected to a signal processor (20a; 20Aa; 20b) for converting sound waves to plural intermediate acoustic signals (S1, S2, S3, S4, DS1, DS2, DS3, DS4), said signal processor (20a; 20Aa, 20b; 20f) carrying out a signal processing on said plural intermediate acoustic signals (S1, S2, S3, S4, DS1, DS2, DS3, DS4) so as to produce a composite acoustic signal (S5; S5a; S5b; S5e), said semiconductor microphone (1a; 1Aa; 1b; 1c; 1d; 1e) comprising an acoustic transducer unit (10; 10A/ 10C) for converting said sound waves to said intermediate acoustic signals (S5; S5a; S5b; S5e),
**characterized by** further comprising
a housing (30a; 30Aa; 30b) having an inner space, and formed with a sound hole (34a; 34Aa; 34bA, 34bB, 34bC, 34bD) which permits said sound waves to enter said inner space,
in that
said acoustic transducer unit (10; 10A/ 10C) includes plural acoustic transducers (11A, 11B, 11C, 11D; 11A', 11C') accommodated in said inner space, having respective values of sensitivity different from one another and respective values of saturated sound pressure of said sound waves different from one another, converting said sound waves to said plural intermediate acoustic signals (S1, S2, S3, S4, DS1, DS2, DS3, DS4), respectively, and providing said plural intermediate acoustic signals (S1, S2, S3, S4, DS1, DS2, DS3, DS4) to said signal processor (20a; 20Aa; 20b).

2. The semiconductor microphone as set forth in claim 1, in which said signal processor (20a; 20Aa; 20b) is accommodated in said inner space together with said plural acoustic transducers (11A, 11B, 11C, 11D; 11A', 11C').

3. The semiconductor microphone as set forth in claim 2, in which said signal processor includes (20a; 20Aa; 20b)
a composition controller (22a/ 22b/ 22c/ 22d/ 22E/ 22f, 222, 223a/ 223b, 224, 225) selecting at least one optimum acoustic signal (DS1/ DS2/ DS3/ DS4) from said plural intermediate acoustic signals (S1, S2, S3, S4, DS1, DS2, DS3, DS4) on the basis of a current value of the sound pressure of said sound waves and changing said at least one optimum acoustic signal (DS1, DS2, DS3, DS4) depending upon said current value of said sound pressure, and
a composer (22a/ 22b/ 22c/ 22d/ 22E/ 22f, 226aA, 226aB, 226aC/ 226bA, 226bB, 226bC) connected to said composition controller (22a/ 22b/ 22c/ 22d/ 22E/ 22f, 222, 223a/ 223b, 224, 225) and producing said composite acoustic signal (S5; S5a; S5b; S5e) from said at least one optimum acoustic signal (DS1/ DS2/ DS3/ DS4).

4. The semiconductor microphone as set forth in claim 3, in which said composition controller (22a/ 22b/ 22c/ 22d/ 22E/ 22f, 222, 223a/ 223b, 224, 225) includes
a selector (22a/ 22b/ 22c/ 22d/ 22E/ 22f, 222, 223a/ 223b, 224) selecting one of said plural intermediate acoustic signals (S1, S2, S3, S4, DS1, DS2, DS3, DS4) as said at least one optimum acoustic signal (DS1/ DS2/ DS3/ DS4) in a sound pressure range except for vicinities of the values of said saturated sound pressure (THA (PA), THB (PB), THC (PC)) and more than one intermediate acoustic signal (S1, S2, S3, S4, DS1, DS2, DS3, DS4) as said at least one optimum acoustic signal (DS1/ DS2/ DS3/ DS4) in said vicinities of said values of said saturated sound pressure (THA (PA), THB (PB), THC (PC)), and
a determiner (22a/ 22b/ 22c/ 22d/ 22E/ 22f, 225) connected to said selector (22a/ 22b/ 22c/ 22d/ 22E/ 22f, 222, 223a/ 223b, 224) and supplying said composer (22a/ 22b/ 22c/ 22d/ 22E/ 22f, 226aA, 226aB, 226aC/ 226bA, 226bB, 226bC) parameters for merging said more than one optimum acoustic signal (DS1/ DS2/ DS3/ DS4) into said composite acoustic signal (S5; S5a; S5b; S5e).

5. The semiconductor microphone as set forth in claim 4, in which said parameters make said composer (22a/ 22b/ 22c/ 22d/ 22E/ 22f, 226aA, 226aB, 226aC/ 226bA, 226bB, 226bC) merge said more than one optimum acoustic signal (DS1/ DS2/ DS3/ DS4) into said composite acoustic signal (S5; S5a; S5b; S5e) through a fading technique while said current value of said sound pressure is being found in said vicinities of said values of said saturated sound pressure (THA (PA), THB (PB), THC (PC)).

6. The semiconductor microphone as set forth in claim 3, in which said composer (22a/ 22b/ 22c/ 22d/ 22E/ 22f, 226aA, 226aB, 226aC/ 226bA, 226bB, 226bC) includes
a normalization unit (22a/ 22b/ 22c/ 22d/ 22E/ 22f, 226aA/ 226aB/ 226aC; 226bA/ 226bB/ 226bC) normalizing said intermediate acoustic signals (DS1/ DS2/ DS3/ DS4) with respect to one of said plural intermediate acoustic signals (DS4) serving as a reference signal on the basis of said values of said sensitivity, and
a merging unit (22a/ 22b/ 22c/ 22d/ 22E/ 22f, 227a/ 227b/ 230) producing said composite acoustic signal (S5; S5a; S5b; S5e) from one of the normalized intermediate acoustic signals in a sound pressure range except for vicinities of the values of said saturated sound pressure (THA (PA), THB (PB), THC (PC)) and more than one normalized intermediate acoustic signal in said vicinities of said values of said saturated sound pressure (THA (PA), THB (PB), THC (PC)).

7. The semiconductor microphone as set forth in claim 6, in which said merging unit adds (22b/ 22c, 227b/ 227c) values of said normalized intermediate acoustic signals (DS1/ DS2/ DS3) to a value of said reference signal (DS4) for determining a sum, and devices said sum by the number of said intermediate acoustic signals (DS1/ DS2/ DS3/ DS4) so as to determine a current value of said composite acoustic signal (S5a, S5b).

8. The semiconductor microphone as set forth in claim 6, in which said normalizing unit (22d, 226bA/ 226bB/ 226bC) further carries out the normalization on the basis of a value of said reference signal (DS4) and values of the normalized intermediate acoustic signal (DS1/ DS2/ SD3) except for said reference signal (DS4).

9. The semiconductor microphone as set forth in claim 3, in which said signal processor further includes an endower (22E, 232, 233A/ 233B/ 233C/ 233D, 234) endowing said composite acoustic signal (S5e) with a directivity.

10. The semiconductor microphone as set forth in claim 9, in which said endower includes
a directivity control unit (22E, 232) determining more than one of said plural acoustic transducers (11A, 11B, 11C, 11D) participating in the endowment of said directivity for the sound waves propagated from a particular direction (DR) and calculating the amount of delay time excessively consumed until said sound waves arrive at said more than one of said plural acoustic transducers (11A, 11B, 11C, 11D) except for one of said plural acoustic transducers serving as a reference transducer,
a delay unit (22E, 233A/ 233B/ 233C/ 233D) connected to said directivity control unit (22E, 232) and introducing said amount of delay time into propagation of said intermediate acoustic signals (DS1, DS2, DS3, DS4) so as to make said sound waves simultaneously arrive at said more than one of said plural acoustic transducers (11A, 11B, 11C, 11D), and
an emphasizing unit (22E, 234) connected to said directivity control unit (22E, 232) and said delay unit (22E, 233A/ 233B/ 233C/ 233D) and carrying out a calculation on the delayed intermediate acoustic signals for emphasizing the sound waves propagating in said particular direction (DR).

11. The semiconductor microphone as set forth in claim 2, in which said plural acoustic transducers (11A, 11B, 11C, 11D; 11A', 11C') are of the type having a stationary electrode (16) and a vibratory electrode (15) spaced from said stationary electrode (16), and makes said sound waves converted to said intermediate acoustic signals (S1, S2, S3, S4) through variation of capacitance between said stationary electrode (16) and said vibratory electrode (15).

12. The semiconductor microphone as set forth in claim 11, in which said plural acoustic transducers (11A, 11B, 11C, 11D) are fabricated on a single semiconductor chip (10).

13. The semiconductor microphone as set forth in claim 12, in which said single semiconductor chip (10) is packaged together with another semiconductor chip where said signal processor (22a, S1 to S37) is fabricated.

14. The semiconductor microphone as set forth in claim 11, in which the vibratory electrodes (15) of said plural acoustic transducers (11A, 11B, 11C, 11D; 11A', 11C') are different in dimensions from one another so as to make said values of said sensitivity different from one another.

15. The semiconductor microphone as set forth in claim 1, further comprising at least one equalizer (250a, 250b, 250c, 250d) provided in association with said plural acoustic transducers (11A, 11B, 11C, 11D) for compensating distortion of sound-to-signal converting characteristics of said plural acoustic transducers.

16. A semiconductor microphone (1e) for converting sound waves to a composite acoustic signal, comprising:
a housing (30b) having an inner space;
plural acoustic transducers (11A, 11B, 11C, 11D) provided in said inner space, and converting said sound waves to plural intermediate acoustic signals; and
a signal processor (20b) connected to said plural acoustic transducers (11A, 11B, 11C, 11D) for producing a composite acoustic signal,
**characterized by** further comprising
a partition wall structure (36, 37, 38) provided in said inner space so as to divide said inner space into plural compartments open to the outside of said housing (30b) selectively through plural sound holes (34bA, 34bB, 34bC, 34bD) formed in said housing (30b),
and in that
said signal processor has an endower (23) introducing delay into selected ones of said plural intermediate acoustic signals so as to produce delayed acoustic signals and forming said composite acoustic signal from said delayed acoustic signals, thereby giving directivity to said semiconductor microphone.
